(19) Europäisches Patentamt
European Patent Office
Office européen des brevets

(11) EP 2 319 892 A1

(12) EUROPEAN PATENT APPLICATION
published in accordance with Art. 153(4) EPC

(43) Date of publication:
**11.05.2011 Bulletin 2011/19**

(21) Application number: **09809946.8**

(22) Date of filing: **26.08.2009**

(51) Int Cl.:
***C09J 201/00*** $^{(2006.01)}$ ***C09J 4/02*** $^{(2006.01)}$
***C09J 7/00*** $^{(2006.01)}$ ***C09J 7/02*** $^{(2006.01)}$
***C09J 163/00*** $^{(2006.01)}$ ***C09J 179/08*** $^{(2006.01)}$
***C09J 201/06*** $^{(2006.01)}$ ***H01L 21/52*** $^{(2006.01)}$

(86) International application number:
**PCT/JP2009/064871**

(87) International publication number:
**WO 2010/024295 (04.03.2010 Gazette 2010/09)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **27.08.2008 JP 2008218047**
**30.04.2009 JP 2009110888**

(71) Applicant: **Hitachi Chemical Company, Ltd.**
**Tokyo 163-0449 (JP)**

(72) Inventors:
- **KAWAMORI Takashi**
**Tsukuba-shi**
**Ibaraki 300-4247 (JP)**
- **MITSUKURA Kazuyuki**
**Tsukuba-shi**
**Ibaraki 300-4247 (JP)**
- **MASUKO Takashi**
**Tsukuba-shi**
**Ibaraki 300-4247 (JP)**
- **KATOGI Shigeki**
**Tsukuba-shi**
**Ibaraki 300-4247 (JP)**

(74) Representative: **von Kreisler Selting Werner**
**Deichmannhaus am Dom**
**Bahnhofsvorplatz 1**
**50667 Köln (DE)**

# (54) PHOTOSENSITIVE ADHESIVE COMPOSITION, PHOTOSENSITIVE FILM ADHESIVE, ADHESIVE PATTERN, SEMICONDUCTOR WAFER WITH ADHESIVE, SEMICONDUCTOR DEVICE AND ELECTRONIC COMPONENT

(57) A photosensitive adhesive composition that can form an adhesive layer on an adherend and allows an adhesive pattern to be formed by exposure treatment with radiation and developing treatment with a developing solution, the photosensitive adhesive composition having solubility and developability, and the film thickness $T_1$ ($\mu$m) of the adhesive pattern formed after development satisfying the conditions represented by the following expression (1).

$$(T_1/T_0) \times 100 \geq 90 \ldots (1)$$

[In expression (1), $T_0$ represents the film thickness ($\mu$m) of the adhesive layer before developing treatment.]

*Fig.27*

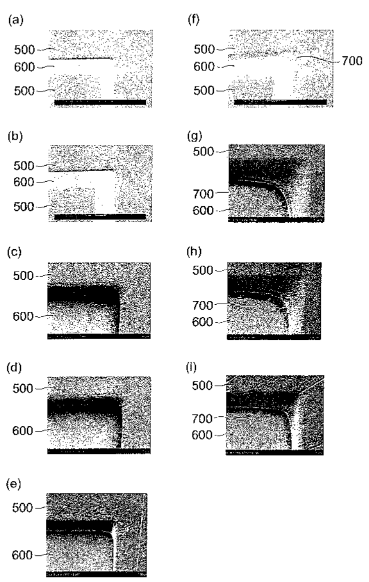


EP 2 319 892 A1

## Description

### Technical Field

The present invention relates to a photosensitive adhesive composition, and to a photosensitive film adhesive, adhesive pattern, semiconductor wafer with an adhesive, semiconductor device and electronic component, obtained using it.

### Background Art

Various forms of semiconductor devices have been proposed in recent years to meet the demands of higher performance and function for electronic components. Adhesives for adhesive anchoring between semiconductor elements and semiconductor element-mounting support bases are used in the production of semiconductor devices. Such adhesives must have properties including low-stress properties, low-temperature adhesion, moisture-proof reliability and solder reflow resistance, and pattern formability is also required for semiconductor device function, and for simplification of the form and assembly process.

Photosensitive film adhesives with a photosensitive property are suitably used as adhesives with pattern formability. Photosensitivity is the function whereby sections irradiated with light are chemically altered to become insolubilized or solubilized in aqueous alkali solutions or organic solvents. Utilizing this property, it is possible to expose a photosensitive film adhesive through a photomask and develop it to form a desired pattern.

Known compositions for photosensitive adhesives with pattern formability include combinations of photoreactive resins with alkali-soluble thermoplastic resins, or further combinations with thermosetting resins if necessary. The materials used for such adhesive compositions have hitherto been, for example, polyimide resin precursors (polyamide acids) or materials comprising polyimide resins as base polymers (for example, see Patent documents 1-3). These materials are superior in terms of heat resistance, but a high temperature of 300°C or higher is required for the former during thermal cyclizing imidation, and for the latter during working. This has led to problems such as high thermal damage to surrounding materials, and greater tendency for thermal stress. In addition, it has been difficult to achieve high levels for both pattern formability with alkali developing solutions and low-temperature attachment property onto adherends, and the reheat contact bondability after exposure and the adhesive force after post-curing have often been inadequate.

In order to overcome these problems there have been proposed adhesive compositions comprising low-Tg (Tg: glass transition temperature) polyimide resins and epoxy resins (see Patent document 4, for example).

### Citation List

### Patent Literature

[Patent document 1] JP 2000-290501 A
[Patent document 2] JP 2001-329233 A
[Patent document 3] JP 11-24257 A
[Patent document 4] WO/2007/004569

### Summary of Invention

### Technical Problem

It has been shown, through research by the present inventors, that the reliability and production yield of semiconductor devices are often reduced with increasing fineness of the adhesive pattern, even with the adhesive composition described in Patent document 4. Specifically, it was found that when an adhesive layer is provided on a semiconductor wafer and subjected to exposure and development, the unexposed sections of the adhesive remain for an extended period as a film in the developing solution after development, and re-attach to the pattern-forming sections (the exposed sections of the adhesive), making it impossible to obtain a consistent pattern width, or they re-attach onto the circuit sections and thereby lower the semiconductor device production yield. One factor is that with conventional photosensitive adhesive compositions that contain low-Tg polyimide resins and epoxy resins, heat applied during formation or film-shaping of the adhesive layer on the adherend causes the ends of the molecular chains of the low-Tg polyimide resin in the adhesive composition to react with the epoxy resin, thus lowering the alkali solubility of the unexposed sections,

and causing the unexposed sections to peel off from the adherend as a film in the pattern formation. The present inventors believe that when this tendency toward peeling becomes too great, the aforementioned problem of re-attachment occurs more easily.

The present inventors have also found that when the solubility of the photosensitive adhesive composition in the developing solution is increased to facilitate dissolution of the unexposed sections in the developing solution, or in other words to strengthen the tendency toward dissolution, the semiconductor device reliability and production yield are often reduced due to connection defects resulting from insufficient adhesive force. The present inventors believe that this occurs because variation in the film thickness occurs after pattern formation, and non-bonded sections are created even when the adherend is contact bonded onto the adhesive pattern.

The present invention has been accomplished in light of these circumstances, and its object is to provide a photosensitive adhesive composition that, for bonding of a semiconductor element, allows high-yield production of a semiconductor device even when a high-definition adhesive pattern has been formed, as well as a photosensitive film adhesive, an adhesive pattern, a semiconductor wafer with an adhesive, a semiconductor device and an electronic component that are obtained using it.

## Solution to Problem

In order to solve the problems mentioned above, the present inventors conducted much diligent research based on the aforementioned knowledge and considerations, regarding the developing mode or variation in film thickness after development, which had not been adequately examined with photosensitive adhesive compositions of the prior art. As a result, it was found that a photosensitive adhesive composition having solubility and developability and a specific film residue rate for the adhesive pattern formed after development, allows formation of an adhesive pattern with sufficient solubility and developability and exhibiting sufficient adhesive force, and the invention has been completed upon this finding.

Specifically, the invention provides a photosensitive adhesive composition that can form an adhesive layer on an adherend and allows an adhesive pattern to be formed by exposure treatment with radiation and developing treatment with a developing solution, the photosensitive adhesive composition having solubility and developability, and the film thickness $T_1$ (μm) of the adhesive pattern formed after development satisfying the conditions represented by the following expression (1).

$$(T_1/T_0) \times 100 \geq 90 \ldots \quad (1)$$

[In expression (1), $T_0$ represents the film thickness (μm) of the adhesive layer before developing treatment.]

According to the photosensitive adhesive composition of the invention, it is possible to produce a semiconductor device at high yield even when a high-definition adhesive pattern has been formed during bonding of a semiconductor element.

The photosensitive adhesive composition of the invention preferably comprises (A) an alkali-soluble resin, (B) a photoinitiator, (C) an epoxy resin and (D) a radiation-polymerizable compound. A composition having such a composition and satisfying the condition specified above has pattern formability with satisfactory solubility and a satisfactory film residue rate, and also exhibits a sufficient subsequent re-adhesion property.

From the viewpoint of improving the reliability after curing, the (A) alkali-soluble resin is preferably a polyimide resin or polyamideimide resin.

From the viewpoint of improving developability, the polyimide resin or polyamideimide resin is preferably a polymer obtained by reaction between an acid monomer and a diamine monomer, the acid monomer preferably comprising a monofunctional acid anhydride and tetracarboxylic dianhydride.

From the viewpoint of improving developability and the low-temperature attachment property, the diamine monomer preferably comprises a diamine with at least a propylene ether skeleton in the molecule.

The photosensitive adhesive composition of the invention preferably further comprises (E) a filler, from the viewpoint of improving reliability.

The invention further provides a photosensitive film adhesive comprising the photosensitive adhesive composition of the invention shaped into a film.

The invention still further provides an adhesive pattern that is formed by forming an adhesive layer composed of the photosensitive adhesive composition of the invention on an adherend, exposing the adhesive layer, and developing the exposed adhesive layer with a developing solution.

The invention still further provides a semiconductor wafer with an adhesive layer, comprising a semiconductor wafer and an adhesive layer composed of the photosensitive adhesive composition according to the invention, formed

on one side of the semiconductor wafer. Using such a semiconductor wafer with an adhesive layer, and providing an adhesive layer composed of the photosensitive adhesive composition according to the invention, it is possible to produce a semiconductor device at high yield even when a high-definition adhesive pattern has been formed during bonding of a semiconductor element.

The invention still further provides a semiconductor device having a structure with a semiconductor element and glass bonded together using the photosensitive adhesive composition according to the invention.

The invention still further provides a semiconductor device having a structure with a semiconductor element and a semiconductor element-mounting supporting member or semiconductor element bonded together using the photosensitive adhesive composition according to the invention. The semiconductor device of the invention, in which a semiconductor element and a semiconductor element-mounting supporting member or another semiconductor element are bonded by the photosensitive adhesive composition of the invention exhibiting the effect described above, is also adequately suitable for simplifying the production process, and has excellent reliability.

The invention still further provides an electronic component comprising the semiconductor device of the invention.

## Effects of Invention

According to the invention it is possible to provide a photosensitive adhesive composition that, for bonding of semiconductor elements, allows high-yield production of semiconductor devices even when a high-definition adhesive pattern has been formed, as well as a photosensitive film adhesive, an adhesive pattern, a semiconductor wafer with an adhesive, a semiconductor device and an electronic component that are obtained using it.

## Brief Description of Drawings

Fig. 1 is a schematic cross-sectional view showing an embodiment of a photosensitive film adhesive according to the invention.

Fig. 2 is a schematic cross-sectional view showing an embodiment of an adhesive sheet according to the invention.

Fig. 3 is a schematic cross-sectional view showing another embodiment of an adhesive sheet according to the invention.

Fig. 4 is a cross-sectional view showing an embodiment of a semiconductor device according to the invention.

Fig. 5 is a cross-sectional view showing an embodiment of a method for producing a semiconductor device according to the invention.

Fig. 6 is a cross-sectional view showing an embodiment of a method for producing a semiconductor device according to the invention.

Fig. 7 is a cross-sectional view showing an embodiment of a method for producing a semiconductor device according to the invention.

Fig. 8 is a cross-sectional view showing an embodiment of a method for producing a semiconductor device according to the invention.

Fig. 9 is a cross-sectional view showing an embodiment of a method for producing a semiconductor device according to the invention.

Fig. 10 is a cross-sectional view showing an embodiment of a method for producing a semiconductor device according to the invention.

Fig. 11 is an end view showing another embodiment of a method for producing a semiconductor device according to the invention.

Fig. 12 is an end view showing another embodiment of a method for producing a semiconductor device according to the invention.

Fig. 13 is a plan view showing another embodiment of a method for producing a semiconductor device according to the invention.

Fig. 14 is an end view showing another embodiment of a method for producing a semiconductor device according to the invention.

Fig. 15 is an end view showing another embodiment of a method for producing a semiconductor device according to the invention.

Fig. 16 is an end view showing another embodiment of a method for producing a semiconductor device according to the invention.

Fig. 17 is an end view showing another embodiment of a method for producing a semiconductor device according to the invention.

Fig. 18 is an end view showing another embodiment of a method for producing a semiconductor device according to the invention.

Fig. 19 is an end view showing another embodiment of a method for producing a semiconductor device according to the invention.

Fig. 20 is an end view showing another embodiment of a method for producing a semiconductor device according to the invention.

Fig. 21 is an end view showing another embodiment of a method for producing a semiconductor device according to the invention.

Fig. 22 is a plan view showing another embodiment of a method for producing a semiconductor device according to the invention.

Fig. 23 is an end view showing another embodiment of a method for producing a semiconductor device according to the invention.

Fig. 24 is a plan view showing another embodiment of a method for producing a semiconductor device according to the invention.

Fig. 25 is an end view showing a semiconductor device produced by the method for producing a semiconductor device according to the invention.

Fig. 26 is a cross-sectional view showing a CMOS sensor employing a semiconductor device produced by the method for producing a semiconductor device according to the invention.

Fig. 27 is an SEM photograph of a pattern formed with a photosensitive adhesive composition according to the invention.

Fig. 28 is a schematic cross-sectional view of a pattern formed with a photosensitive adhesive composition according to the invention.

Fig. 29 is a plan view showing a pattern shape of a photomask A.

## Description of Embodiments

Preferred embodiments of the photosensitive adhesive composition of the invention will now be explained in detail with reference to the accompanying drawings as necessary.

The photosensitive adhesive composition of the invention has solubility and developability, and the film thickness of the adhesive pattern formed after development is at least 90% of the film thickness of the adhesive layer before development. Throughout the present specification, the ratio (%) of the thickness of the adhesive layer (adhesive pattern) after development with respect to the thickness of the adhesive layer before development will be referred to as "film residue rate".

The "solubility and developability", for the purpose of the invention, is a property whereby residue of large flakes of polymers and the like does not easily remain on the adhesive pattern obtained by pattern formation, or a property whereby residue of large flakes of polymers and the like does not easily remain in the developing solution after development during pattern formation. The "residue" referred to here refers to flakes of unexposed sections that fail to dissolve and are dispersed in the developing solution, or flakes of unexposed sections that fail to dissolve and remain attached to the exposed sections. During pattern formation, preferably there are essentially no large flakes of polymers and the like remaining as residue on the adhesive pattern obtained by pattern formation. That is, preferably no visibly discernible residue is observed in the adhesive pattern formed by pattern formation, and preferably the width of residue on the unexposed sections is no greater than 1/20, and more preferably no greater than 1/30, of the pattern width of the exposed sections when observed with an optical microscope or SEM. Also, preferably essentially no large flakes of polymers and the like remain as residue in the developing solution after development, during pattern formation. That is, preferably no visibly discernible residue is observed in the developing solution after development, and preferably the size of the residue is no greater than 1/20 of the width of the formed pattern, and more preferably no greater than 1/30 of the width of the formed pattern, when observed with an optical microscope or SEM. When the photosensitive adhesive composition contains a filler, the filler must not be regarded as the residue. That is, when a resin with solubility and developability is used, it is possible to reduce large flakes of the unexposed sections in the developing solution after development, and to reduce residue of the unexposed sections remaining without dissolution in the formed adhesive pattern (exposed sections).

The solubility and developability can be confirmed by a method of confirming residue of the adhesive pattern obtained by pattern formation, or a method of confirming residue in the developing solution after development.

The method of confirming the solubility and developability by residue of the adhesive pattern obtained by pattern formation is as follows. A varnish of the photosensitive adhesive composition is prepared, and a 3 μm adhesive layer composed of the photosensitive adhesive composition is formed on an adherend such as a mirror surface treated side of a silicon wafer. The adhesive layer is formed by coating the photosensitive adhesive composition varnish on the adherend by spin coating, and heating the coating film for 3 minutes at a temperature of 100°C or higher to remove the

solvent. When a photosensitive film adhesive is prepared beforehand from the photosensitive adhesive composition, the adhesive layer is formed by laminating the photosensitive film adhesive on the circuit side of a semiconductor element such as a silicon wafer, while using a roll for pressing at a temperature of preferably 20-150°C. In this case the film thickness of the prepared photosensitive film adhesive is 50 μm. After the adhesive layer has been formed, a photomask bearing a drawn pattern (for example, a photomask bearing a 1 mm-wide drawn pattern) is placed on the adhesive layer, and exposure is performed through the photomask at an exposure dose of 1000 $mJ/cm^2$ and followed by heating at 80°C for 30 seconds. When the adhesive layer has been prepared by spin coating, a photograph vat of a size in which the entire wafer fits is filled with developing solution, and an exposure-treated wafer with an adhesive is dipped in the developing solution so that the entirety is wetted. After dipping, a spin developer is used for spray washing at a pressure of at least 0.01 MPa. The residue remaining in the formed pattern is then observed. When a photosensitive film adhesive has been used to form an adhesive layer, a spin developer is used for spraying of the developing solution for 30 seconds at a pressure of at least 0.01 MPa, and then spray washing is performed at a pressure of at least 0.01 MPa. The residue remaining in the formed pattern is then observed. Fig. 28 is a schematic cross-sectional view of a pattern formed with a photosensitive adhesive composition according to the invention. In an adhesive layer 803 having a pattern formed on a semiconductor wafer 804, "dissolving development" (having solubility and developability) is considered to be cases where the width 802 of the residue 700 of the unexposed sections is no greater than 1/20 of the pattern width 801 of the exposed sections 500, while "detaching development" (no solubility and developability) is considered to be cases where the width 802 of the residue 700 of unexposed sections is greater than 1/20 of the width 801 of the pattern of exposed sections.

The method of confirming solubility and developability based on residue in the developing solution after development is as follows. A varnish of the photosensitive adhesive composition is prepared, and a 3 μm adhesive layer composed of the photosensitive adhesive composition is formed on an adherend such as a mirror surface treated side of a silicon wafer. The adhesive layer is formed by coating the photosensitive adhesive composition varnish on the adherend by spin coating, and heating the coating film for 3 minutes at a temperature of 100°C or higher to remove the solvent. When a photosensitive film adhesive is prepared beforehand from the photosensitive adhesive composition, the adhesive layer is formed by laminating the photosensitive film adhesive on the circuit side of a semiconductor element such as a silicon wafer, while using a roll for pressing at a temperature of preferably 20-150°C. In this case the film thickness of the prepared photosensitive film adhesive is 50 μm. After the adhesive layer has been formed, a photomask bearing a 1 mm-wide drawn pattern is placed on the adhesive layer, and exposure is performed through the photomask at an exposure dose of 1000 $mJ/cm^2$ and followed by heating at 80°C for 30 seconds. A photograph vat of a size in which the entire wafer fits is filled with developing solution, and an exposure-treated wafer with an adhesive is dipped in the developing solution so that the entirety is wetted. After confirming relief of the pattern image based on the difference in degree of penetration of the developing solution for the exposed sections and unexposed sections, the wafer is removed from the photograph vat, a washing bottle is used to pour water onto the wafer with the adhesive, with the photograph vat placed below, and the residue of unexposed sections adhering to the wafer is returned to the photograph vat. The developing solution containing the residue of unexposed sections remaining on the photograph vat is allowed to stand for 5 minutes for dissolution of the residue, and cases where the size of the remaining residue is no greater than 1/20 of the width of the formed pattern is evaluated as "dissolving development" (having solubility and developability), while those where the size of the remaining residue is greater than 1/20 of the width of the formed pattern is evaluated as "detaching development" (no solubility and developability).

Judgment of solubility and developability according to the invention is accomplished by a method of confirmation based on residue of the adhesive pattern obtained by pattern formation.

There are no particular restrictions on the shape of the pattern, and it may be in the form of a frame, lines or through-holes.

According to the invention, dissolving development when the photosensitive adhesive composition is a negative type is such that the unexposed sections of the adhesive layer dissolve in the developing solution, and an adhesive pattern is formed essentially without the adhesive layer of the unexposed sections remaining as large residue in the developing solution after development. Also according to the invention, dissolving development when the photosensitive adhesive composition is a positive type is such that the exposed sections of the adhesive layer dissolve in the developing solution, and an adhesive pattern is formed essentially without the adhesive layer of the exposed sections remaining as large residue in the developing solution after development.

Furthermore, according to the invention, such residue is preferably not observed even on the adherend or adhesive pattern.

When the photosensitive adhesive composition does not have solubility and developability, and an adhesive layer composed of the photosensitive adhesive composition has been subjected to exposure and development, a large amount of undissolved adhesive layer remains as residue in the developing solution, and not only does this re-attach to the adherend, but when a pattern with L-shapes and the like has been formed, the solubility of the bent sections is insufficient and they have a high tendency to remain as development residue on the adherend (see Fig. 27(f)-(i), for

example). When such residual matter and development residue remain in large amounts, the residual matter or development residue adheres to the effective picture element regions of adherends such as image sensors, very often resulting in defects. With semiconductor elements and the like, the presence of residue or extraneous material in the joints causes jamming of resin at the joints, resulting in notable deterioration of the electrical characteristics.

The photosensitive adhesive composition of the invention can effectively prevent this problem. In addition, the photosensitive adhesive composition of the invention allows improvement in pattern formability by solubility and developability, so that patterns with higher definition can be formed. As it is expected that products employing photosensitive film adhesives will continue to be downsized in the future, high-definition pattern formability is believed to be essential. The photosensitive adhesive composition of the invention is adequately suitable also for downsizing of products employing photosensitive film adhesives.

In order to realize a photosensitive adhesive composition with solubility and developability, an alkali-soluble polymer may be added, or the molecular weight of the polymer may be reduced. A large molecular weight will tend to cause aggregation of the polymer, rendering it non-homogeneous and resulting in reduced solubility and developability. The method for reducing the molecular weight of the polymer may involve control of the reaction for polymer synthesis. A polymer such as polyimide is produced by extending condensation of a monomer, and controlling the extension reaction can reduce the molecular weight. For example, a substance that controls the extension reaction may be added to the reaction system during polymer synthesis. As a specific example, a monofunctional acid anhydride may be added to the reaction system during synthesis of a polyimide by reaction between a tetracarboxylic dianhydride and a diamine. This can control the extension reaction to yield a polyimide with low molecular weight. Using such a polyimide allows a photosensitive adhesive composition with solubility and developability to be obtained.

When a photosensitive adhesive composition of the invention with such a polymer added is used for bonding of a semiconductor element, solid resin matter that has not dissolved in the developing solution after development does not easily remain, and therefore residue of the solid resin matter on the semiconductor element can be inhibited. This allows elimination of defects such as migration, that is caused by residue of solid resin matter. It also makes it possible to prevent mechanical trouble (clogging of tubes) caused by solid resin matter in the waste liquid.

The photosensitive adhesive composition of the invention, in addition to its solubility and developability, also has a film thickness of the adhesive pattern after development that is at least 90% of the film thickness of the adhesive layer before development, and variations in the film thickness of the patterned adhesive can be adequately reduced. This allows the area of the non-bonded sections to be reduced when an adherend is freshly bonded to an adhesive pattern, thus facilitating production of highly reliable semiconductor devices and electronic components.

In order to realize a film thickness of the adhesive pattern after development that is at least 90% of the film thickness of the adhesive layer before development, the crosslink density of the adhesive layer in the exposed sections after exposure may be adjusted. Low crosslink density is a cause of reduced developing solution resistance, and tends to lower the film residue rate after development. Examples of methods for adjusting the crosslink density after exposure include methods of selecting the radiation-polymerizable compound, and methods of adjusting the addition amount. For example, a method of selecting the radiation-polymerizable compound by selection of a radiation-polymerizable compound with a large number of functional groups can improve the crosslink density after exposure. Alternatively, for the addition amount, the crosslink density can be improved by increasing the amount of radiation-polymerizable compound added. For example, considering a film residue rate of at least 90% after exposure, the content of the radiation-polymerizable compound is preferably 40-200 parts by weight with respect to 100 parts by weight of the polyimide or other alkali-soluble resin. When a monofunctional acrylate/methacrylate or bifunctional acrylate/methacrylate is used as the radiation-polymerizable compound, and considering a film residue rate of at least 90% after exposure, the content is preferably at least 70 parts by weight with respect to 100 parts by weight of the alkali-soluble resin. When a trifunctional or greater acrylate/methacrylate is used as the radiation-polymerizable compound, and considering a film residue rate of at least 90% after exposure, the content is preferably at least 40 parts by weight with respect to 100 parts by weight of the alkali-soluble resin. There is no problem with using these acrylates/methacrylates in combination. These ensure sufficient developing solution resistance and can increase the film residue rate after development, allowing a film residue rate of at least 90% after development to be obtained. If the radiation-polymerizable compound content is less than 40 parts by weight, the solvent resistance after exposure will be reduced, allowing formation of a pattern but tending to result in a residue rate of less than 90%.

In addition, one embodiment of the photosensitive adhesive composition of the invention is a photosensitive adhesive composition that allows formation of an adhesive pattern by forming an adhesive layer on an adherend and performing exposure treatment with radiation and developing treatment with a developing solution, the photosensitive adhesive having solubility and developability, and the film thickness $T_1$ ($\mu$m) of the adhesive pattern formed after development satisfying the conditions represented by the following expression (1).

$$(T_1/T_0) \times 100 \geq 90 \ldots (1)$$

[In expression (1), $T_0$ represents the film thickness (μm) of the adhesive layer before developing treatment.]

Preferably, essentially no residue of the adhesive layer is observed in the developing solution after developing treatment. By "essentially no residue of the adhesive layer is observed in the developing solution after developing treatment" is meant that no flakes of the adhesive layer are seen when the developing solution is visually observed after developing treatment, and that upon observation using an optical microscope or SEM, the size of the residue is no greater than 1/10 of the width of the pattern that has been formed

The thickness of the adhesive layer and adhesive pattern is determined using a surface roughness measuring instrument (product of Kosaka Laboratory, Ltd.).

For this embodiment, the aforementioned residue is preferably not observed even on the semiconductor element or adhesive pattern. Also, when $T_0$ is 1-200 μm in this embodiment, preferably no development residue is present on the semiconductor element and the wall face of the adhesive pattern is roughly perpendicular to the semiconductor element surface.

The photosensitive resin composition of this embodiment may be a negative type. In this case, the residue of the adhesive layer is the residue of the adhesive layer in the unexposed sections, and the film thickness of the adhesive pattern is the film thickness of the exposed sections of the adhesive layer after developing treatment.

The photosensitive resin composition of this embodiment is also preferably one that is capable of dissolving development with an alkali developing solution. In this case, the developing solution used for the developing treatment is preferably a 2.38% aqueous solution of tetramethylammonium hydride (TMAH).

The photosensitive adhesive composition of this embodiment has solubility and developability, and when the adhesive layer has been formed and subjected to exposure, heating and developing treatment as described hereunder, the film residue rate ($(T_1/T_0) \times 100$) is preferably at least 90% and more preferably at least 95%.

The method of forming the adhesive layer on the semiconductor element may be either of the following two types of methods. The first method is a method in which a varnish of the photosensitive adhesive composition is prepared and coated on the circuit side of the semiconductor element, such as a silicon wafer, by spin coating at a rotational speed of preferably 400 rpm or greater for 10 seconds or longer, and the coating film is heated at a temperature of at least 100°C for 3 minutes or longer to remove the solvent and form an adhesive layer. The second method is a method in which a photosensitive film adhesive is prepared beforehand from the photosensitive adhesive composition and is laminated on the circuit side of a semiconductor element such as a silicon wafer, while using a roll for pressing at a temperature of preferably 20-150°C. $T_0$ is preferably set to within a range of 1-200 μm. When coating is performed by spin coating, $T_0$ is more preferably set to 3 μm, and when a photosensitive film adhesive is formed, $T_0$ is more preferably set to 50 μm.

The exposure treatment may be accomplished by a method of placing a photomask on the adhesive layer, and using a high precision parallel exposure apparatus (product of Orc Manufacturing Co., Ltd.) for ultraviolet irradiation under conditions with an exposure dose of 100-10000 mJ/cm$^2$. The irradiated ultraviolet rays may be ultraviolet rays obtained by using a "UV-SN35" spectrometer with a peak at 365 nm, which employs an ultraviolet irradiation lamp that emits ultraviolet rays of 200 nm or longer as the light source. The exposure dose is preferably set to 1000 mJ/cm$^2$.

Heat treatment may be heating with a hot plate at 80°C-120°C, for a period of 5-30 seconds. The heating conditions are preferably set to 80°C, 30 seconds.

The developing treatment may be carried out by a method of dipping the heated adhesive layer in a developing solution, or a method of spraying the developing solution onto the adhesive layer. Such methods allow the developing solution to penetrate into the adhesive layer. When the adhesive layer has been formed by spin coating, the developing treatment is preferably accomplished by a method of dipping the adhesive layer in the developing solution for 5 seconds or longer and preferably 10 seconds or longer, and then washing it by spray pressure of at least 0.01 MPa for 10 seconds or longer and preferably 30 seconds or longer. Developing treatment when the adhesive layer is formed by pressing of the photosensitive film adhesive may be accomplished by a method of spray development at a spray pressure of at least 0.01 MPa, preferably at least 0.1 MPa, more preferably at least 0.5 MPa for 10 seconds or longer and preferably 30 seconds or longer, followed by washing at a spray pressure of at least 0.01 MPa for 10 seconds or longer and preferably 30 seconds or longer. From the viewpoint of preventing peeling of the adhesive layer, the upper limit for the spray pressure is about 1.0 MPa.

The developing treatment is preferably carried out using a 1.0-5.0% aqueous solution and more preferably a 2.38% solution of tetramethylammonium hydride (TMAH), as the developing solution.

The photosensitive adhesive composition of the invention preferably comprises (A) an alkali-soluble resin, (B) a photoinitiator, (C) an epoxy resin and (D) a radiation-polymerizable compound. A composition having such a composition and satisfying the condition specified above has pattern formability with satisfactory solubility and a satisfactory film

residue rate, and also exhibits a sufficient subsequent re-adhesion property.

The photosensitive resin composition of the invention preferably further comprises (E) a filler.

Each of the components in the photosensitive adhesive composition of the invention will now be explained in detail.

From the viewpoint of heat resistance, adhesion and film formability, the (A) alkali-soluble resin used for the invention is preferably (A1) a polyimide resin or a polyamideimide resin.

Also, the polyimide resin or polyamideimide resin is preferably a polymer obtained by reaction between an acid monomer and a diamine monomer (hereinafter referred to simply as "diamine"), the acid monomer preferably being obtained by reacting a monofunctional acid anhydride and a tetracarboxylic dianhydride.

A polyimide resin can be obtained by condensation and dehydrating cyclization of a tetracarboxylic dianhydride and diamine by a known method, during which a monofunctional acid anhydride is added during the condensation reaction to obtain the polyimide resin. As used herein, a monofunctional acid anhydride is a compound having one acid anhydride structure in the molecule. Reaction of a monofunctional acid anhydride can convert the ends of the polyimide resin molecular chains to ends having low reactivity with epoxy resins, and can further improve the developability. Also, addition of a monofunctional acid anhydride during the condensation reaction can inhibit the condensation reaction and yield a polymer of low molecular weight. If such a polymer is added the solubility and developability can be further improved.

There are no particular restrictions on the monofunctional acid anhydride used as the starting material for the polyimide resin, but preferably a monofunctional acid anhydride represented by any of the following formulas (i)-(iii) is used. In particular, a monofunctional acid anhydride represented by formula (i) has a terminal carboxylic acid group and therefore can further improve the developability with alkali developing solutions.

[Chemical Formula 1]

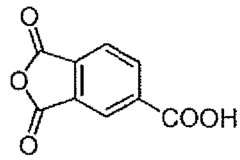

( i )

[Chemical Formula 2]

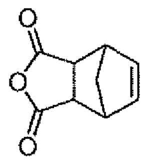

( ii )

[Chemical Formula 3]

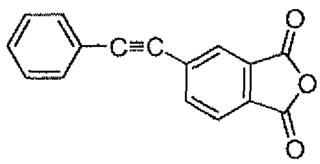

( iii )

The amount of monofunctional acid anhydride used is preferably at least 10 mol%, more preferably at least 15 mol% and even more preferably at least 20 mol% of the total acid anhydride used for the reaction. The upper limit is preferably 50 mol%. If the amount of monofunctional acid anhydride used is less than 10 mol% it will be difficult to obtain the desired properties, and if it is greater than 50 mol% the polymer synthesis may be hampered and an adverse effect may be exhibited on film formability.

Monofunctional acid anhydrides other than those of formulas (i)-(iii) above include trimellitic anhydride chloride,

4-ethynylphthalic anhydride, 4-methylphthalic anhydride, 4-tert-butylphthalic anhydride, 3-methylphthalic anhydride, 4-nitrophthalic anhydride, 1,2-naphthalic anhydride, 2,3-naphthalenedicarboxylic anhydride, 3-methyl-4-cyclohexene-1,2-dicarboxylic anhydride, 4-methyl-4-cyclohexene-1,2-dicarboxylic anhydride, bicyclo[2.2.2]oct-5-ene-2,3-dicarboxylic anhydride, cis-4-cyclohexene-1,2-dicarboxylic anhydride, exo-3,6-epoxy-1,2,3,6-tetrahydrophthalic anhydride, 4-methylcyclohexane-1,2-dicarboxylic anhydride, cis-1,2-cyclohexanedicarboxylic anhydride and (±)-trans-1,2-cyclohexanedicarboxylic anhydride.

Examples of tetracarboxylic dianhydrides to be used as starting materials for the polyimide resin include pyromellitic dianhydride, 3,3',4,4'-biphenyltetracarboxylic dianhydride, 2,2',3,3'-biphenyltetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylenetetracarboxylic dianhydride, bis(3,4-dicarboxyphenyl)ether dianhydride, benzene-1,2,3,4-tetracarboxylic dianhydride, 3,3',4,4'-benzophenonetetracarboxylic dianhydride, 2,2',3,3'-benzophenonetetracarboxylic dianhydride, 3,3',4,4'-benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,4,5-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,5,6-tetracarboxylic dianhydride, 2,3,3',4'-biphenyltetracarboxylic dianhydride, 3,3',4,4'-biphenyltetracarboxylic dianhydride, 2,2',3,3'-biphenyltetracarboxylic dianhydride, bis(3,4-dicarboxyphenyl)dimethylsilane dianhydride, bis(3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, p-phenylenebis(trimellitate anhydride), ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetraearboxylic dianhydride, bis(exo-bicyclo[2,2,1]heptane-2,3-dicarboxylic dianhydride, bicyclo-[2,2,2]-oct-7-ene-2,3,5,6-tetracarboxylic dianhydride, 2,2-bis(3,4-dicarboxyphenyl)propane dianhydride, 2,2-bis[4-(3,4-dicarboxyphenyl)phenyl]propane dianhydride, 2,2-bis(3,4-dicarboxyphenyl)hexafluoropropane dianhydride, 2,2-bis[4-(3,4-dicarboxyphenyl)phenyl]hexafluornpropane dianhydride, 4,4'-bis(3,4-dicarboxyphenoxy)diphenyl sulfide dianhydride, 1,4-bis(2-hydroxyhexafluoroisopropyl)benzenebis(trimellitic anhydride), 1,3-bis(2-hydroxyhexafluorozsoprapyl)benzenebis(trimellitic anhydride), 5-(2,5-dioxatetrahydrofuryl)-3-methyl-3-cyclohexene-1,2-dicarbaxylic dianhydride, tetrahydrofuran-2,3,4,5-tetracarboxylic dianhydride, and tetracarboxylic dianhydrides represented by the following formula (iv).

[Chemical Formula 4]

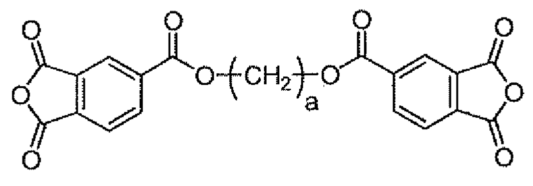

(iv)

[In the formula, a represents an integer of 2-20.]

A tetracarboxylic dianhydride represented by formula (iv) can be synthesized from trimellitic anhydride monochloride and its corresponding diol, for example, and specifically there may be mentioned 1,2-(ethylene)bis(trimellitate anhydride), 1,3 -(trimethylene)bis(trimellitate anhydride), 1,4-(tetramethylene)bis(trimellitate anhydride), 1,5-(pentamethylene)bis(trimellitate anhydride), 1,6-(hexamethylene)bis(trimellitate anhydride), 1,7-(heptamethylene)bis(trimellitate anhydride), 1,8-(octamethylene)bis(trimellitate anhydride), 1,9-(nonamethylene)bis(trimellitate anhydride), 1,10-(decamethylene)bis(trimellitate anhydride), 1,12-(dodecamethylene)bis(trimellitate anhydride), 1,16-(hexadecamethylene)bis(trimellitate anhydride) and 1,18-(octadecamethylene)bis(trrmellitate anhydride).

From the viewpoint of imparting satisfactory solubility and moisture-proof reliability to the solvent, tetracarboxylic dianhydrides represented by the following formula (v) are particularly preferred.

[Chemical Formula 5]

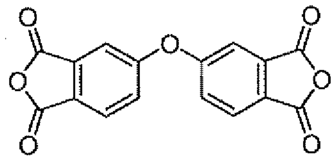

(v)

Any of these acid anhydrides may be used alone or in combinations of two or more.

The diamine used as a starting material for the polyimide resin is preferably a diamine containing a propylene ether skeleton in the skeleton of the main chain. By including a propylene ether skeleton in the skeleton of the main chain, affinity with the developing solution is increased and improvement in developability may be expected, while the Tg of the polyimide used can also be lowered.

Examples of diamines containing propylene ether skeletons include diamines represented by the following formula (vi).

[Chemical Formula 6]

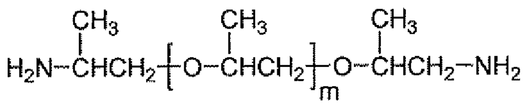

(vi)

(In the formula, m represents an integer of 0-80.)

Specifically there may be mentioned aliphatic diamines, including polyoxyalkylenediamines such as JEFFAMINE ED-230 and ED-400 by San Techno Chemical Co., Ltd., and polyetheramine D-230, D-400, D-600 and D-2000 by BASF.

These diamines are preferably used at 1-70 mol% of the total diamine used for the reaction. It will thus be possible to easily prepare a polyimide resin having solubility and developability.

Examples of other diamines to be used as starting materials for the polyimide resin include aromatic diamines such as o-phenylenediamine, m-phenylenediamine, p-phenylenediamine, 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylether methane, bis(4-amino-3,5-dimethylphenyl)methane, bis(4-amino-3,5-dirsopropylphenyl)methane, 3,3'-diaminodiphenyldifluoromethane, 3,4'-diaminodiphenyldifluoromethane, 4,4'-diaminadiphenyldifluoromethane, 3,3'-diaminodiphenylsulfone, 3,4'-diaminodiphenylsulfone, 4,4'-diaminodiphenylsulfone, 3,3'-diaminodiphenyl sulfide, 3,4'-diaminodiphenyl sulfide, 4,4'-diaminodiphenyl sulfide, 3,3'-diaminodiphenylketone, 3,4'-diaminadiphenylketone, 4,4'-diaminodiphenylketane, 2,2--bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3 -bis(3-aminophenoxy)benzene, 1,4-bis(3-aminophenoxy)benzene, 1,4-bis(4-aminophenoxy)benzene, 3,3'-(1,4-phenylenebis(1-methylethylidene))bisaniline, 3,4'-(1,4-phenylenebis(1-methylethylidene))bisaniline, 4,4'-(1,4-phenylenebis(1-methylethylidene))bisaniline, 2,2-bis(4-(3-aminophenoxy)phenyl)propane, 2,2-bis(4-(3-aminophenoxy)phenyl)hexafluoropropane, 2,2-bis(4-(4-aminophenoxy)phenyl)hexafluoropropane, bis(4-(3-aminoenoxy)phenyl)sulfide, bis(4-(4-aminoenoxy)phenyl)sulfide, bis(4-(3-aminoenoxy)phenyl)sulfone, bis(4-(4-aminoenoxy)phenyl)sulfone, 3,3'-dihydroxy-4,4'-diaminobiphenyl and 3,5-diaminobenzoic acid, 1,3-bis(aminomethyl)cyclohexane, 2,2-bis(4-aminophenoxyphenyl)propane, aliphatic etherdiamines represented by the following formula (vii) and aliphatic diamines represented by the following formula (viii).

[Chemical Formula 7]

$$H_2N-Q^1\left(O-Q^2\right)_b O-Q^3-NH_2 \qquad \text{(vii)}$$

[In the formula, $Q^1$, $Q^2$ and $Q^3$ each independently represent a C1-10 alkylene group, and b represents an integer of 2-80.]

[Chemical Formula 8]

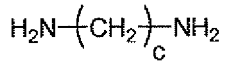 ( viii )

[In the formula, c represents an integer of 5-20.]

For improved solubility in alkali developing solutions, it is particularly preferred to use a carboxyl-containing diamine represented by the following formula (ix) or (x). From the viewpoint of improved adhesive force after curing, it is preferred to use a siloxane skeleton-containing diamine represented by the following formula (xi).

[Chemical Formula 9]

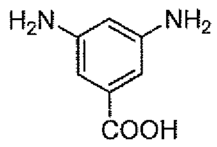 ( ix )

[Chemical Formula 10]

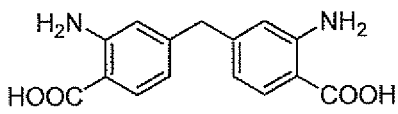 ( x )

[Chemical Formula 11]

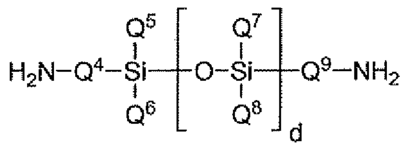 ( xi )

[In the formulas, $Q^4$ and $Q^9$ each independently represent a C1-5 alkylene or optionally substituted phenylene group, $Q^5$, $Q^6$, $Q^7$ and $Q^8$ each independently represent a C1-5 alkyl, phenyl or phenoxy group, and d represents an integer of 1-5.]

Siloxane skeleton-containing diamines represented by chemical formula (xi) include 1,1,3,3-tetramethyl-1,3-bis(4-aminophenyl)disiloxane, 1,1,3,3-tetraphenoxy-1,3-bis(4-aminoethyl)disiloxane, 1,1,3,3-tetraphenyl-1,3-bis(2-amanoethyl)disiloxane, 1,1,3,3-tetraphenyl-1,3-bis(3-aminopropyl)disiloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(3-aminobutyl)disiloxane and 1,3-dimethyl-1,3-dimethoxy-1,3-bis(4-aminobutyl)disiloxane.

Any of the aforementioned diamines may be used alone or in combinations of two or more.

A polyimide resin obtained in the manner described above may be used alone, or two or more thereof may be used in admixture (blend) as necessary, during preparation of the photosensitive adhesive composition.

The attachable temperature of the photosensitive adhesive composition of the invention after pattern formation is preferably no higher than 200°C, more preferably no higher than 180°C and even more preferably no higher than 150°C, from the viewpoint of inhibiting warping of the semiconductor wafer. In order to allow attachment at such a temperature, the Tg of the polyimide resin used is preferably 10-150°C, more preferably 10-100°C and even more preferably 20-80°C. If the Tg of the polyimide resin exceeds 150°C, this will increase the potential for the attachment

temperature onto wafer back sides to exceed 100°C, while if the Tg is below 10°C, the pressure-sensitive adhesive force of the film surface will be stronger in the B-stage state and the manageability will tend to be impaired, and therefore neither extreme is desirable.

The weight-average molecular weight of the polyimide resin is preferably controlled to within the range of 10000-100000, more preferably 20000-80000, even more preferably 20000-60000 and most preferably 20000-30000. If the weight-average molecular weight is within this range, the film formability, pliability and tear resistance of the photosensitive adhesive composition of the invention will be suitable when it is formed into a sheet or film. If the weight-average molecular weight is less than 10000, the film formability will tend to be impaired or the toughness of the film will tend to be reduced, and if it exceeds 100000 an adverse effect may be exhibited on the pattern formability.

If the Tg and weight-average molecular weight of the polyimide resin are within the ranges specified above, it will not only be possible to lower the attachment temperature onto wafer back sides, but it will also be possible to impart pattern formability and low-temperature adhesion properties. The Tg referred to above is the primary dispersion peak temperature of the polyimide, which is the tan$\delta$ peak temperature as measured using an ARES rotary rheometer (product of Rheometric Scientific), with the polymer sandwiched between parallel circular plates (diameter: 8 mm) and under conditions with a frequency of 1 Hz, a strain of 1%, a temperature-elevating rate of 5°C/min and a measuring temperature of 30°C-304°C. The weight-average molecular weight is the weight-average molecular weight measured in terms of polystyrene using high-performance liquid chromatography (C-R4A, product of Shimadzu Corp.).

The (B) photoinitiator is not particularly restricted, but from the viewpoint of improving sensitivity, the molecular absorption coefficient for light with a wavelength of 365 nm is preferably at least 500 ml/g·cm and more preferably at least 1000 ml/g·cm. The molecular absorption coefficient can be determined by preparing a 0.001 wt% acetonitrile solution of the sample and measuring the absorbance of the solution using a spectrophotometer ("U-3310" (trade name) by Hitachi High-Technologies Corp.).

The (B) photoinitiator preferably includes a photoinitiator that undergoes bleaching by photoirradiation. Examples of such photoinitiators include compounds that undergo photo-discoloration under UV irradiation, among aromatic ketones such as 2-benzyl-2-dimethylamino-1-(4-morpholinophenyl)-butanone-1, 2,2-dimethoxy-1,2-diphenylethan-1-one, 1-hydroxy-cyclohexyl-phenyl-ketone, 2-methyl-1-(4-(methylthio)phenyl)-2-morpholinopropanone-1, 2,4-diethylthioxanthone, 2-ethylanthraquinone and phenanthrenequinone, benzyl derivatives such as benzyldimethylketal, 2,4,5-triarylimidazole dimers such as 2-(o-chlorophenyl)-4,5-diphenylimidazole dimer, 2-(o-chlorophenyl)-4,5-di(m-methoxyphenyl)imxdazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer and 2-(2,4-dimethoxyphenyl)-4,5-diphenylimidazole dimer, acridine derivatives such as 9-phenylacridine and 1,7-bis(9,9'-acridinyl) heptane, and bisacylphosphine oxides such as bis(2,6-dimethoxybenzoyl)-2,4,4-trimethyl-pentylphosphine oxide and bis(2,4,6,-trimethylbenzoyl)-phenylphosphine oxide. These may be used alone or in combinations of two or more types.

A compound that exhibits a function of promoting polymerization of the epoxy resin by exposure to radiation may also be used as the (B) photoinitiator. From the viewpoint of promoting polymerization of the epoxy resin by exposure to radiation, the photoinitiator preferably contains a compound that generates a base by exposure to radiation.

Any compound that generates a base by exposure to radiation (photobase generator), if it is a compound that generates a base upon irradiation, may be used without any particular restrictions. Strongly basic compounds are preferred as bases to be generated, from the viewpoint of reactivity and curing speed. The pH value is generally used as the index of basicity, and the pH value is preferably 7 or greater and more preferably 9 or greater in aqueous solution.

Examples of bases generated by irradiation include imidazole and imidazole derivatives such as 2,4-dimethylimidazole and 1-methylimidazole, piperazine and piperazine derivatives such as 2,5-dimethylpiperazine, piperidine and piperidine derivatives such as 1,2-dimethylpiperidine, proline derivatives, trialkylamine derivatives such as trimethylamine, triethylamine and triethanolamine, pyridine derivatives with amino groups or alkylamino groups substituting at the 4-position, such as 4-methylaminopyridine or 4-dimethylaminopyridine, pyrrolidine and pyrrolidine derivatives such as n-methylpyrrolidine, dihydropyridine derivatives, alicyclic amine derivatives such as triethylenediamine and 1,8-diazabicyclo[5.4.0]undeca-7-ene (DBU), and benzylamine derivatives such as benzylmethylamine, benzyldimethylamine and benzyldiethylamine.

As photobase generators that generate such bases by irradiation there may be used, for example, the quaternary ammonium salt derivatives described in Journal of Photopolymer Science and Technology Vol. 12, 313-314 (1999) or Chemistry of Materials Vol. 11, 170-176 (1999). These are optimal for curing of the epoxy resin, because of the generation of trialkylamines with high basicity by exposure to active light rays.

As photobase generators, there may be also used the carbamic acid derivatives mentioned in Journal of American Chemical Society Vol. 118 p.12925(1996) or Polymer Journal Vol. 28 p.795(1996).

As compounds that generate bases by irradiation with active light rays there may be used oxime derivatives, and 2-benzyl-2-dimethylamino-1-(4-morpholinophenyl)-butanone-1, 2,2-dimethoxy-1,2-diphenylethan-1-one, 2-methyl-1-(4-(methylthio)phenyl)-2-morpholinopropan-1-one, 2-benzyl-2-dimethylamino-1-(4-morpholinophenyl)-butanone-1, hexaarylbisimidazole derivatives (with substituents such as halogens, alkoxy, nitro or cyano optionally substituting on

the phenyl groups), benzoisooxazolone derivatives, and the like, which are commercially available as photoradical generators.

The photobase generator may also employ a compound having a base-generating group introduced on the main chain and/or a side chain of the polymer. The molecular weight in this case is preferably a weight-average molecular weight of 1000-100000 and more preferably 5000-30000, from the viewpoint of adhesion, flow property and heat resistance of the adhesive.

Since the photobase generator does not exhibit reactivity with the epoxy resin when not exposed to radiation at room temperature, it has highly excellent storage stability at room temperature.

By adding a compound that generates a base by exposure to radiation, as a photoinitiator, it is possible to apply heat to the adherend after photoirradiation so that the base generated at the photoirradiated sections promotes curing of the epoxy resin, thus forming a more satisfactory pattern.

The photosensitive adhesive composition of the invention may also be used with a sensitizing agent if necessary. Examples of sensitizing agents include camphorquinone, benzyl, diacetyl, benzyldimethylketal, benzyldiethylketal, benzyldi(2-methoxyethyl)ketal, 4,4'-dimethylbenzyl-dimethylketal, anthraquinone, 1-chloroanthraquinone, 2-chloroanthraquinone, 1,2-benzanthraquinone, 1-hydroxyanthraquinone, 1-methylanthraquinone, 2-ethylanthraquinone, 1-bromoanthraquinone, thioxanthone, 2-isopropylthioxanthone, 2-nitrothioxanthone, 2-methylthioxanthone, 2,4-dimethylthioxanthone, 2,4-diethylthioxanthone, 2,4-diisopropylthioxanthone, 2-chloro-7-trifluoromethylthioxanthone, thioxanthone-10,10-dioxide, thioxanthone-10-oxide, benzoinmethyl ether, benzoinethyl ether, isopropyl ether, benzoinisobutyl ether, benzophenone, bis(4-dimethylaminophenyl)ketane, 4,4'-bisdiethylaminobenzophenone and azide group containing compounds. These may be used alone or in combinations of two or more.

When heat is applied for curing of an epoxy resin that still has non-crosslinked sections after a photoinitiator has been used for photoirradiation, it is preferred to use a curing agent or curing accelerator for the epoxy resin, and more preferably they are used in combination.

Examples of curing agents include phenol-based compounds, aliphatic amines, alicyclic amines, aromatic polyamines, polyamides, aliphatic acid anhydrides, alicyclic acid anhydrides, aromatic acid anhydrides, dicyandiamides, organic acid dihydrazides, boron trifluoride amine complexes, imidazoles, tertiary amines, and phenol-based compounds having at least two phenolic hydroxyl groups in the molecule, among which phenol-based compounds having at least two phenolic hydroxyl groups in the molecule are preferred from the viewpoint of high solubility in aqueous alkali solutions.

Examples of phenol-based compounds having at least two phenolic hydroxyl groups in the molecule include phenol-novolac resins, cresol-novolac resins, t-butylphenol-novolac resins, dicyclopentadienecresol-novolac resins, dicyclopentadienephenol-novolac resins, xylylene-modified phenol-novolac resins, naphthol-novolac resins, trisphenol-novolac resins, tetrakisphenol-novolac resins, bisphenol A-novolac resins, poly-p-vinylphenol resins and phenolaralkyl resins.

The curing accelerator is not particularly restricted so long as it accelerates curing of the epoxy resin, and examples thereof include imidazoles, dicyandiamide derivatives, dicarboxylic acid dihydrazides, triphenylphosphine, tetraphenylphosphoniumtetraphenyl borate, 2-ethyl-4-methylimidazole-tetraphenyl borate and 1,8-diazabicydo[5.4.0] undecene-7-tetraphenyl borate.

The amount of epoxy resin curing agent used is preferably 0.1-200 parts by weight with respect to 100 parts by weight of the epoxy resin, and the amount of curing accelerator is preferably 0.1-50 parts by weight with respect to 100 parts by weight of the epoxy resin.

The (C) epoxy resin is preferably one containing at least two epoxy groups in the molecule, and it is more preferably a phenol glycidyl ether-type epoxy resin from the viewpoint of curability and cured properties. Examples of such resins include bisphenol A-type (or AD-type, S-type and F-type) glycidyl ethers, hydrogenated bisphenol A-type glycidyl ethers, ethylene oxide adduct bisphenol A-type glycidyl ethers, propylene oxide adduct bisphenol A-type glycidyl ethers, phenol-novolac resin glycidyl ethers, cresol-novolac resin glycidyl ethers, bisphenol A-novolac resin glycidyl ethers, naphthalene resin glycidyl ethers, trifunctional (or tetrafunctional) glycidyl ethers, dicyclopentadienephenol resin glycidyl ethers, dimer acid glycidyl esters, trifunctional (or tetrafunctional) glycidylamines, naphthalene resin glycidylamines, and the like.

These epoxy resins may be used alone or in combinations of two or more. When two or more are used in combination, it is most preferred to use in combination an epoxy resin that is solid and an epoxy resin that is liquid at room temperature. A solid epoxy resin is preferred from the viewpoint of improved adhesion after curing, while a liquid epoxy resin is preferred for an improved flow property during adhesion after pattern formation.

The photosensitive adhesive composition of this embodiment preferably further comprises (D) a radiation-polymerizable compound. The radiation-polymerizable compound may be any compound that undergoes polymerization and/or curing by exposure to radiation such as ultraviolet rays or an electron beam, and examples thereof include methyl acrylate, methyl methacrylate, ethyl acrylate, ethyl methacrylate, butyl acrylate, butyl methacrylate, 2-ethylhexyl acrylate, 2-ethylhexyl methacrylate, pentenyl acrylate, tetrahydrofurfuryl acrylate, tetrahydrofurfuryl methacrylate, diethyleneglycol diacrylate, triethyleneglycol diacrylate, tetraethyleneglycol diacrylate, diethyleneglycol dimethacrylate, triethyleneglycol

dimethacrylate, tetraethyleneglycol dimethacrylate, trimethylolpropane diacrylate, trimethylolpropane triacrylate, trimethylolpropane dimethacrylate, trimethylolpropane trimethacrylate, 1,4-butanediol diacrylate, 1,6-hexanediol diacrylate, 1,4-butanediol dimethacrylate, 1,6-hexanediol dimethacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, styrene, divinylbenzene, 4-vinyltoluene, 4-vinylpyridine, N-vinylpyrrolidone, 2-hydroxyl acrylate, 2-hydroxyethyl methacrylate, 1,3-acryloyloxy-2-hydxoxypropane, 1,2-methacryloyloxy-2-hydroxypropane, methylenebisacrylamide, N,N-dimethylacrylamide, N-methylolacrylamide, triacrylates such as tris(β-hydroxyethyl)isocyanurate, bisphenol A EO-modified diacrylates and bisphenol F EO-modified diacrylates, as well as isocyanuric acid-modified diacrylates and isocyanuric acid-modified triacrylates represented by the following formula (xii), ε-caprolactone-modified tris(acryloxyethyl)isocyanurate, or pentaerythritol pentaacrylate, pentaerythritol pentamethacrylate, ditrimethylolpropane tetraacrylate, epoxy acrylates, polyether acrylates, polyester acrylates, acryl acrylates, compounds represented by the following formula (xiii), urethane acrylates or urethane methacrylates, and urea acrylates.

[Chemical Formula 12]

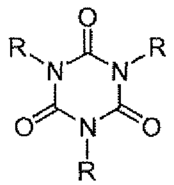

(xii)

[In the formula, R represents hydrogen or a C0-30 organic group containing a methacrylate group or acrylate group.]

[Chemical Formula 13]

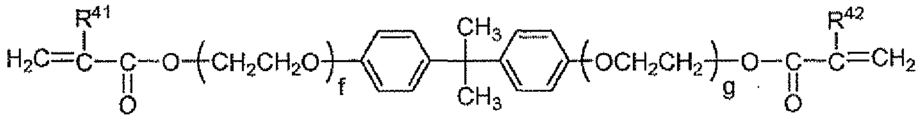

(xiii)

[In the formula, $R^{41}$ and $R^{42}$ each independently represent hydrogen or a methyl group, and f and g each independently represent an integer of 1 or greater.]

In addition to these compounds, there may be used as the (D) radiation-polymerizable compound, radiation-polymerizable copolymers having ethylenic unsaturated groups on side chains, which are obtained by addition reaction of a compound having at least one ethylenic unsaturated group and a functional group such as an oxirane ring or an isocyanate, hydroxyl or carboxyl group, with a functional group-containing vinyl copolymer. These (D) radiation-polymerizable compounds may be used alone or in combinations of two or more.

The amount of (D) radiation-polymerizable compound used for the invention is preferably 40-200 parts by weight, from the viewpoint of adhesive force and more preferably 70-100 parts by weight, from the viewpoint of pattern formability and adhesive force, with 100 parts by weight as the weight of the polyimide or other alkali-soluble resin used in the adhesive composition. A content of greater than 200 parts by weight for the radiation-polymerizable compound will tend to lower the flow property during heat-fusion due to polymerization, thus reducing the adhesion after thermocompression bonding. A content of less than 40 parts by weight will tend to lower the solvent resistance after light exposure, and while allowing pattern formation, will tend to result in a residual film thickness of no greater than 90%.

The photosensitive adhesive composition of this embodiment preferably contains (E) a filler. There are no particular restrictions on the filler used, but from the viewpoint of improving sensitivity of the photosensitive adhesive composition, it is preferably a silica filler with a spherical and primary mean particle size of no greater than 1 μm. When a filler is used, its amount is preferably no greater than 100 parts by weight and more preferably no greater than 50 parts by weight with respect to 100 parts by weight of the polyimide or other alkali-soluble resin. The lower limit is not particularly restricted but will normally be 5 parts by weight. If the amount used is less than 5 parts by weight, it will be difficult to obtain an effect of improving the hot adhesion and an effect of increasing the residue rate of the film thickness after development. If the amount of filler exceeds 100 parts by weight, the UV permeability will be poor and pattern formation will tend to be difficult, while adhesion will also tend to be reduced.

As the index of UV permeability, the transmittance at 400 nm is preferably at least 10% and more preferably

at least 20%, when a 50 μm-thick film is measured using an UV meter.

The photosensitive adhesive composition of this embodiment preferably also contains (F) a thermal radical generator. By using a thermal radical generator it is possible for the unreacted radiation-polymerizable compound remaining after irradiation during pattern formation to react during thermal curing, and this is preferred from the viewpoint of increasing the post-curing reliability. The thermal radical generator used is preferably an organic peroxide, and preferably the 1 minute half-life temperature is a temperature at least 20°C higher than the drying temperature during formation of a film of the photosensitive adhesive composition.

Compounds represented by the following formulas (xiv) and (xv), in particular, are preferred because they have a high 1 minute half-life temperature and their reaction as radical generators at the film molding temperature is inhibited.

[Chemical Formula 14]

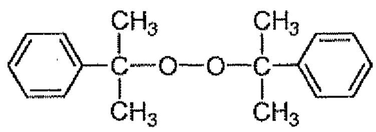

(xiv)

[Chemical Formula 15]

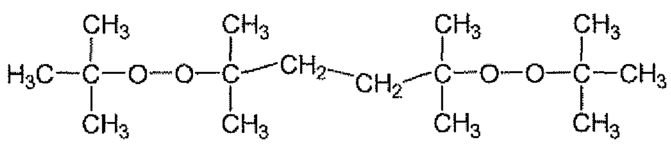

(xv)

The photosensitive adhesive composition may contain a suitable (G) coupling agent for purposes such as increased bonding strength. Examples of coupling agents include silane coupling agents and titanium-based coupling agents, among which silane-based coupling agents are preferred for a greater effect, and compounds with thermosetting groups such as epoxy groups or radiation-polymerizable groups such as methacrylate and/or acrylate groups are more preferred.

The boiling point and/or decomposition temperature of the silane-based coupling agent is preferably 150°C or higher, more preferably 180°C or higher and even more preferably 200°C or higher. It is particularly preferred to use a silane-based coupling agent with a boiling point and/or decomposition temperature of 200°C or higher, and having thermosetting groups such as epoxy groups or radiation-polymerizable groups such as methacrylate and/or acrylate groups. The amount of coupling agent used is preferably 0.01-20 parts by weight with respect to 100 parts by weight of the (A) alkali-soluble resin used, from the standpoint of the effect, heat resistance and cost.

When a coupling agent is used, its amount is preferably 0.1-.50 parts by weight and more preferably 0.1-20 parts by weight with respect to 100 parts by weight of the polyimide or other alkali-soluble resin. An amount exceeding 50 parts by weight will tend to reduce the shelf life of the photosensitive adhesive composition.

An (H) ion scavenger may also be added to the photosensitive adhesive composition of this embodiment to adsorb ionic impurities and improve the insulating reliability when wet. Examples of such ion scavengers include compounds known as copper inhibitors to prevent ionization and dissolution of copper, such as triazinethiol compounds and phenol-based reducing agents, as well as inorganic compounds such as powdered bismuth-based, antimony-based, magnesium-based, aluminum-based, zirconium-based, calcium-based, titanium-based and tin-based compounds, as well as mixtures of the same. Specific examples include, but are not restricted to, ion scavengers by Toagosei Co., Ltd. having the trade names of IXE-300 (antimony-based), IXE-500 (bismuth-based), IXE-600 (antimony/bismuth mixture-based), IXE-700 (magnesium/aluminum mixture-based), IXE-800 (zirconium-based) and IXE-1100 (calcium-based). Any of these may be used alone or in mixtures of two or more. The amount of ion scavenger used is preferably 0.01-10 parts by weight with respect to 100 parts by weight of the (A) alkali-soluble resin, such as a polyimide or polyamideimide resin, from the viewpoint of effect of the addition, heat resistance and cost.

Fig. 1 is a schematic cross-sectional view showing an embodiment of a photosensitive film adhesive according to the invention. The photosensitive film adhesive (adhesive film) 1 shown in Fig. 1 is obtained by forming a film from the photosensitive adhesive composition of the invention. Fig. 2 is a schematic cross-sectional view showing an embodiment of an adhesive sheet according to the invention. The adhesive sheet 100 shown in Fig. 2 is constructed of a base film 3, and an adhesive layer composed of a photosensitive film adhesive 1 formed on one side of the base film.

Fig. 3 is a schematic cross-sectional view showing another embodiment of an adhesive sheet according to the invention. The adhesive sheet 110 shown in Fig. 3 is constructed of a base film 3, and an adhesive layer composed of an adhesive film 1, and a cover film 2, formed on one side of the base film.

When the photosensitive adhesive composition of the invention has been formed into a film, the thickness of the photosensitive film adhesive is preferably 1-100 μm. The form of the photosensitive film adhesive of the invention be a monolayer photosensitive film adhesive 1, as shown in Fig. 1. Such a form is preferably a tape-like form with a width of about 1-20 mm or a sheet-like form with a width of about 10-50 cm, and it is transported into a state wound around a winding core. It may also have a structure with the photosensitive film adhesive 1 provided on one side (see Fig. 2) or both sides (not shown) of the base film 3. In order to prevent damage and contamination of the adhesive layer, a cover film 2 may be appropriately provided on the adhesive layer. For example, as shown in Fig. 3, the photosensitive film adhesive may have a structure wherein the photosensitive film adhesive 1 is provided on the base film 3 and a cover film 2 is also provided.

The base film 3 is not particularly restricted so long as it can withstand the drying conditions. For example, a polyester film, polypropylene film, polyethylene terephthalate film, polyimide film, polyetherimide film, polyether naphthalate film or methylpentene film may be used as the base film 3. A film used as the base film 3 may also be a multilayer film comprising a combination of two or more different types, and the surface may be treated with a silicone-based or silica-based release agent.

When the photosensitive adhesive composition is to be prepared as a film form, it may be obtained by a method in which a layer comprising a varnish of the photosensitive adhesive composition is formed on the base film 3, the varnish layer is dried by heat, and then the base 3 is removed. It may also be stored and used as an adhesive sheet 100 or 110, without removal of the base film 3.

Preparation of the photosensitive adhesive composition may be accomplished in the following manner, for example. First, the (A) alkali-soluble resin, such as a polyimide or polyamideimide resin, the (B) photoinitiator, the (C) epoxy resin and the (D) radiation-polymerizable compound, with other components added as necessary, are mixed in an organic solvent, and the mixture is kneaded to prepare a varnish.

The mixing and kneading can generally be accomplished by an appropriate combination of dispersers such as a stirrer, kneader, triple roll or ball mill. Drying of the varnish layer formed by coating on the base film 3 is carried out at a temperature at which the (C) epoxy resin, as the thermosetting resin, does not completely react during drying, and under conditions wherein the solvent adequately volatilizes. Specifically this is accomplished by heating, usually at 60-180°C for 0.1-90 minutes. The preferred thickness of the varnish layer before drying is 1-100 μm, as mentioned above. A thickness of less than 1 μm will tend to impair the adhesive anchoring function, while a thickness of greater than 100 μm will tend to increase the residual volatile components described hereunder.

The temperature at which the epoxy resin does not completely react is, specifically, a temperature below the peak temperature for heat of reaction, with measurement using a DSC (for example, a "Model DSC-7" (trade name) by Perkin-Elmer), with a sample weight of 10 mg, a temperature-elevating rate of 5°C/min and a measuring atmosphere of air.

The preferred residual volatile component of the obtained varnish layer is no greater than 10 wt%. A residual volatile content of greater than 10 wt% will tend to result in more residual voids in the interior of the adhesive layer due to foaming by volatilization of the solvent during the assembly heating, thus tending to impair the moisture-proof reliability. It will also tend to increase the possibility of contaminating the surrounding material or parts by volatile components generated during heating.

The method of calculating the residual volatilizing component is as follows. Specifically, the value for the photosensitive film adhesive cut to a size of 50 mm × 50 mm was measured using $[(M2-M1)/M1] \times 100$ = residual volatile content (%), where M1 is the initial weight and M2 is the weight after heating the photosensitive film adhesive for 3 hours in an oven at 160°C.

The organic solvent used to prepare the varnish, i.e. the varnish solvent, is not particularly restricted so long as it can uniformly dissolve or disperse the material. As examples there may be mentioned dimethylformamide, toluene, benzene, xylene, methyl ethyl ketone, tetrahydrofuran, ethylcellosolve, ethylcellosolve acetate, dioxane, cyclohexanone, ethyl acetate and N-methyl-pyrrolidinone.

The method of forming the adhesive layer of the photosensitive adhesive composition may be a method of spin coating the photosensitive adhesive composition varnish on an adherend such as a silicon wafer, wherein a rotational speed of preferably 400 rpm or greater is applied for 10 seconds or longer to form a film of the adhesive layer, and the adherend is heated at a temperature of 100°C or higher for at least 3 minutes to volatilize off the solvent and form an adhesive layer.

When the photosensitive adhesive composition has been pre-formed into a film by such a method, it is preferably laminated by using a roll to press the silicon wafer or other adherend at a temperature of preferably 20-150°C. The adhesive layer is then subjected to pattern formation.

The semiconductor wafer with an adhesive layer, according to the invention, comprises a semiconductor wafer, and a film-like adhesive (adhesive layer) composed of a photosensitive adhesive composition of the invention formed

on one side thereof The method of forming the adhesive layer on the semiconductor wafer may be a method using the aforementioned photosensitive adhesive composition varnish, or a method of using a photosensitive film adhesive prepared from the photosensitive adhesive composition beforehand.

The thickness of the adhesive layer is preferably 1-200 μm and more preferably 3-50 μm, from the viewpoint of manageability and adhesion.

The adhesive pattern of the invention is formed by forming an adhesive layer composed of a photosensitive adhesive composition of the invention on an adherend, exposing the adhesive layer through a photomask, and developing the exposed adhesive layer with a developing solution. The adhesive pattern of the invention may also be formed by first forming an adhesive layer composed of a photosensitive adhesive composition of the invention on an adherend, subjecting the adhesive layer directly to pattern-rendering exposure using direct writing exposure technology, and developing the exposed adhesive layer with a developing solution.

The adherend may be, for example, a semiconductor element such as silicon wafer or glass, or an organic substrate. When the adherend is a semiconductor element, the adhesive layer is preferably formed on the circuit side, from the viewpoint of protecting the circuit side.

The method of forming the adhesive layer on the adherend may be a method using the aforementioned photosensitive adhesive composition varnish, or a method of using a photosensitive film adhesive prepared from the photosensitive adhesive composition beforehand.

The thickness of the adhesive layer is preferably 1-200 μm and more preferably 3-50 μm, from the viewpoint of manageability and adhesion.

The following conditions may be mentioned as conditions suitable for the pattern formation. Specifically, a mask is placed on the adhesive layer that has been formed on the adherend, and a high precision parallel exposure apparatus (product of Orc Manufacturing Co., Ltd.) is used for exposure with radiation (for example, ultraviolet rays) under conditions with an exposure dose of 100-10000 mJ/$cm^2$, heating is performed at 80°C-120°C for a period of 5-30 seconds, and then a 1.0-5.0% and preferably 2.38% solution of tetramethylammonium hydride (TMAH) is used for development to form a pattern. During this time, an appropriate combination of the exposure dose, the heating temperature and time, and the developing method is preferably selected for a film residue rate of at least 90% before and after exposure. A film residue rate of at least 95% can minimize creation of non-bonded sections caused by variation in the thickness of the photosensitive film adhesive composition, during subsequent thermocompression bonding of a semiconductor element or protective glass.

The adhesive pattern of the invention may also be formed by subjecting an adhesive layer composed of a photosensitive adhesive composition of the invention, directly to pattern-rendering exposure using direct writing exposure technology, and developing the exposed adhesive layer with a developing solution.

Fig. 4 is a schematic cross-sectional view showing an embodiment of a semiconductor device according to the invention. The semiconductor device 201 comprises a board (first adherend) 203 with a connecting terminal (first joint: not shown), a semiconductor chip with a connecting electrode section (second joint: not shown) (second adherend) 205, an insulating resin layer 207 composed of a cured photosensitive adhesive composition of the invention and a conductive layer 209 made of a conductive material. The board 203 has a circuit side 211 opposing the semiconductor element 205, and it is situated at a prescribed spacing from the semiconductor element 205. The insulating resin layer 207 is formed between the board 203 and semiconductor element 205 in contact with both the board 203 and semiconductor element 205, and it has a prescribed pattern. The conductive layer 209 is formed between the board 203 and semiconductor element 205 at the sections where the insulating resin layer 207 is not present. The connecting electrode section of the semiconductor element 205 is electrically connected to the connecting terminal of the board 203 via the conductive layer 209.

Figs. 5 to 9 are cross-sectional views of an embodiment of a method for producing the semiconductor device 201 shown in Fig. 4. The method for producing a semiconductor device according to this embodiment comprises a step of forming an insulating resin layer 207 composed of a photosensitive adhesive composition of the invention on a board 203 having a connecting terminal (an adhesive layer without pattern formation and curing, in this case) (first step: Fig. 5 and Fig. 6), a step of patterning the insulating resin layer 207 by light exposure and development so that openings 213 are formed where the connecting terminal is exposed (second step: Fig. 7 and Fig. 8), a step of filling a conductive material into the openings 213 to form a conductive layer 209 (third step: Fig. 9), and a step of directly bonding a semiconductor element 205 having a connecting electrode section to the insulating resin layer 207 of the stack comprising the board 203 and insulating resin layer 207 (an adhesive layer with pattern formation, in this case), while electrically connecting the connecting terminal of the board 203 to the connecting electrode section of the semiconductor element 205 via the conductive layer 209 (fourth step).

On the circuit side 211 of the board 203 shown in Fig. 5 there is provided an insulating resin layer 207 composed of a photosensitive adhesive composition of the invention (an adhesive layer without pattern formation and curing, in this case) (Fig. 6). According to this embodiment, it is convenient to employ a method in which a photosensitive film adhesive obtained by pre-forming the photosensitive adhesive composition of the invention into a film is prepared and

attached to the board 203. The insulating resin layer may be formed by a method of coating a liquid varnish containing the photosensitive adhesive composition of the invention onto a board 203 by a spin coating method, and heating it to dryness.

The insulating resin layer 207 composed of the photosensitive adhesive composition of the invention may function as a negative type photosensitive adhesive capable of alkali development, and for bonding of a semiconductor element, can form an adhesive pattern with low variation in film thickness even when a high-definition adhesive pattern has been formed by dissolving development. This will allow high-yield production of a semiconductor device with excellent reliability.

The insulating resin layer 207 composed of a photosensitive adhesive composition of the invention, which has been formed on the board 203, is irradiated with active light rays (typically ultraviolet rays) through a mask 215 having openings formed at prescribed locations (Fig. 7). The insulating resin layer 207 is thus exposed in the prescribed pattern.

Following exposure, the sections of the insulating resin layer 207 that were not exposed are removed by dissolving development using an alkali developing solution, so that the insulating resin layer 207 is patterned in a manner such that openings 213 are formed where the connecting terminal of the board 203 is exposed (Fig. 8). The effect of the invention is obtained even if a positive-type photosensitive adhesive is used instead of a negative-type, in which case the sections of the insulating resin layer 207 exposed are removed by development.

A conductive material is filled into the openings 213 of the obtained resist pattern to form a conductive layer 209 (Fig. 9). The method of filling the conductive material may be gravure printing, indenting with a roll, or pressure reduction filling. The conductive material used may be an electrode material composed of a metal or metal oxide such as solder, gold, silver, nickel, copper, platinum, palladium or ruthenium oxide, and it may consist of bumps of such metals or, for example, it may comprise at least conductive particles and a resin component. The conductive particles may be, for example, conductive particles made of a metal or metal oxide of gold, silver, nickel, copper, platinum, palladium or ruthenium oxide, or an organometallic compound. The resin component may be a thermosetting resin composition comprising an epoxy resin and its curing agent, for example.

The semiconductor element 205 is directly bonded onto the insulating resin layer 207 (a pattern-formed adhesive layer, in this case) on the board 203. The connecting electrode section of the semiconductor chip 205 is electrically connected to the connecting terminal of the board 203 via the conductive layer 209. A patterned insulating resin layer (buffer coat film) may be formed on the circuit side of the semiconductor element 205 opposite the insulating resin layer 207 side.

Bonding of the semiconductor element 205 is accomplished by, for example, a method of thermocompression bonding while heating to a temperature at which the pattern-formed adhesive layer exhibits fluidity. After thermocompression bonding, the insulating resin layer 207 is heated if necessary to further promote curing.

A back side protective film is preferably attached to the circuit side (back side) of the semiconductor element 205 opposite the insulating resin layer 207 side.

A semiconductor device 201 having the construction shown in Fig. 4 is thus obtained. The method for producing a semiconductor device according to this embodiment is not limited to the embodiments described above, and it may incorporate appropriate modifications that still fall within the gist of the invention.

For example, an insulating resin layer composed of a photosensitive adhesive composition of the invention is not limited to being formed first on the board 203, and may instead of be formed first on the semiconductor element 205. In this case, the method for producing a semiconductor device comprises, for example, a first step of forming an insulating resin layer 207 composed of a photosensitive adhesive composition of the invention on a semiconductor element 205 having a connecting electrode section, a second step of patterning the insulating resin layer 207 by light exposure and development so that openings 213 are formed where the connecting electrode section is exposed, a third step of filling the conductive material into the openings 213 to form a conductive layer 209, and a fourth step of directly bonding a board 203 having a connecting terminal to the insulating resin layer 207 of the stack comprising the semiconductor element 205 and insulating resin layer 207, while electrically connecting the connecting terminal of the board 203 to the connecting electrode section of the semiconductor element 205 via the conductive layer 209.

In this production method, connection is between the individuated board 203 and semiconductor element 205, and this is preferred from the viewpoint of facilitating connection between the connecting terminal on the board 203 and the connecting electrode section on the semiconductor element 205.

In addition, an insulating resin layer composed of a photosensitive adhesive composition of the invention may be formed first on a semiconductor wafer composed of a plurality of semiconductor elements 205. In this case, the method for producing a semiconductor device comprises, for example, a first step of forming an insulating resin layer 207 composed of a photosensitive adhesive composition of the invention on a semiconductor wafer 217 composed of a plurality of semiconductor elements 205 with connecting electrode sections (Fig. 10), a second step of patterning the insulating resin layer 207 by light exposure and development so that openings 213 are formed where the connecting electrode section is exposed, a third step of filling the openings 213 with a conductive material to form a conductive layer 29, a fourth step of directly bonding a wafer-size board having a connecting terminal (a board having approximately the

same size as a semiconductor wafer) 203 onto the insulating resin layer 207 of the stack comprising the semiconductor wafer 217 and insulating resin layer 207, while electrically connecting the connecting terminal of the board 203 and the connecting electrode section of the semiconductor element 205 composing the semiconductor wafer 217, via the conductive layer 209, and a fifth step of dicing the stack of the semiconductor wafer 217, insulating resin layer 207 and board 203 into semiconductor elements 205.

In this production method, an insulating resin layer 207 composed of a photosensitive adhesive composition of the invention is provided on a wafer-size board 203 in the first step, a semiconductor wafer 217 is directly bonded to the insulating resin layer 207 of the stack comprising the board 203 and insulating resin layer 207 while electrically connecting the connecting terminal of the board 203 with the connecting electrode section of the semiconductor element 205 composing the semiconductor wafer 217 via the conductive layer 209 in the fourth step, and the stack comprising the semiconductor wafer 217, insulating resin layer 207 and board 203 is diced into semiconductor elements 205 in the fifth step.

The step up to connection of the semiconductor wafer 217 and board 203 (fourth step) in this production method are preferred from the viewpoint of working efficiency because they can be carried out with a wafer size. A back side protective film is preferably attached to the circuit side (back side) of the semiconductor wafer 217 opposite the insulating resin layer 207 side.

Another method for producing a semiconductor device comprises a first step of forming an insulating resin layer 207 composed of a photosensitive adhesive composition of the invention on a semiconductor wafer 217 composed of a plurality of semiconductor elements 205 having connecting electrode sections, a second step of patterning the insulating resin layer 207 by light exposure and development so that openings 213 are formed where the connecting electrode sections are exposed, a third step of filling the conductive material into the openings 213 to form a conductive layer 209, a fourth step of dicing the stack comprising the semiconductor wafer 217 and insulating resin layer 207 into semiconductor elements 205, and a fifth step of directly bonding a board 203 having a connecting terminal to the insulating resin layer 207 of the stack comprising the individuated semiconductor elements 205 and insulating resin layer 207, while electrically connecting the connecting terminal of the board 203 to the connecting electrode sections of the semiconductor elements 205 via the conductive layer 209.

In this production method, an insulating resin layer 207 composed of a photosensitive adhesive composition of the invention may be provided on a wafer-size board 203 in the first step, the stack comprising the wafer-size board 203 and insulating resin layer 207 may be diced into semiconductor elements 205 in the fourth step, and the semiconductor elements 205 may be directly bonded to the insulating resin layer 207 of the stack comprising the individuated board 203 and insulating resin layer 207 while electrically connecting the connecting terminal of the board 203 with the connecting electrode sections of the semiconductor elements 205 via the conductive layer 209 in the fifth step.

This production method is preferred in that the steps from formation of the insulating resin layer, that functions as the photosensitive adhesive, to filling of the conductive material (third step), are carried out with a wafer size, and the dicing step (fourth step) can thus be accomplished smoothly.

The photosensitive adhesive composition of the invention may also be used to bond together semiconductor wafers or semiconductor elements to form a semiconductor stack. Through electrodes may also be formed in the stack.

In this case, the method for producing a semiconductor device comprises, for example, a first step of forming an insulating resin layer 207 composed of a photosensitive adhesive composition of the invention on a first semiconductor element 205 having a through electrode-connecting electrode section, a second step of patterning the insulating resin layer 207 by light exposure and development so that openings 213 are formed where the connecting electrode section is exposed, a third step of filling the conductive material into the openings 213 to form through electrode connections, and a fourth step of directly bonding a second semiconductor element 205 having a connecting electrode section to the insulating resin layer 207 of the stack comprising the first semiconductor element 205 and insulating resin layer 207, while electrically connecting together the connecting electrode sections of the first and second semiconductor elements 205 via a conductive layer 209. Semiconductor wafers may be used instead of semiconductor elements in this production method.

Figs. 11, 12, 13, 14, 15 and 16 are end views or plan views showing other embodiments of a method for producing a semiconductor device according to the invention. The method for producing a semiconductor device according to this embodiment comprises a step of forming an adhesive layer 301 composed of a photosensitive adhesive composition of the invention on a circuit side 325 of a semiconductor element 320 that has been formed in a semiconductor wafer 302 (Fig. 11(a), (b)), a step of patterning the adhesive layer 301 formed on the circuit side 325 of the semiconductor element 320 by exposure and development (Fig. 11(c), Fig. 12(a)), a step of polishing the semiconductor element 302 from the side opposite the circuit side 325 to reduce the thickness of the semiconductor element 302 (Fig. 12(b)), a step of cutting the semiconductor wafer 302 into multiple semiconductor elements 320 by dicing (Fig. 12(c), Fig. 14(a)), a step of picking up the semiconductor elements 320 and mounting them on a laminar support base 307 for the semiconductor device (Fig. 14(b), Fig. 15(a)), a step of directly bonding a second semiconductor chip 321 layer on the patterned adhesive layer 301 on the circuit side of the semiconductor element 320 which has been mounted on the support base

307 (Fig. 15(b)), and a step of connecting each of the semiconductor elements 320, 321 to external connecting terminals (Fig. 16).

In the semiconductor wafer 302 shown in Fig. 11(a) there are formed a plurality of semiconductor elements 320 partitioned by dicing lines 390. The adhesive layer 301 is provided on the circuit side 325 side of the semiconductor element 320 (Fig. 11(b)). According to this embodiment, it is convenient to employ a method in which a photosensitive film adhesive obtained by pre-forming the photosensitive adhesive composition of the invention into a film is prepared and attached to the semiconductor wafer 302. The adhesive layer may be formed by a method of coating a liquid varnish containing the photosensitive adhesive composition of the invention onto the semiconductor wafer 302 by a spin coating method, and heating it to dryness.

The adhesive layer 301 composed of the photosensitive adhesive composition of the invention may function as a negative type photosensitive adhesive capable of alkali development, and for bonding of a semiconductor element, can form an adhesive pattern with low variation in film thickness even when a high-definition adhesive pattern has been formed by dissolving development. This will allow high-yield production of a semiconductor device with excellent reliability.

The adhesive layer 301 formed on the semiconductor wafer 302 is irradiated with active light rays (typically ultraviolet rays) via a mask 3 03 having openings formed at prescribed locations (Fig. 11(c)). The adhesive layer 301 is thus exposed in the prescribed pattern.

Following exposure, the sections of the adhesive layer 301 that were not exposed are removed by dissolving development using an alkali developing solution, so that the adhesive layer 301 is patterned in a manner such that openings 311 are formed (Fig. 12(a)). The effect of the invention is obtained even if a positive-type photosensitive adhesive is used instead of a negative-type, in which case the sections of the insulating resin layer 207 exposed are removed by development.

Fig. 13 is a plan view showing the patterned state of an adhesive layer 301. An end view along line II-II of Fig. 13 is shown in Fig. 12(a). The bonding pads of semiconductor elements 320 are exposed at the openings 311. That is, the patterned adhesive layer 301 is the buffer coat film of the semiconductor elements 320. A plurality of rectangular openings 311 are formed in rows on each semiconductor element 320. The shapes, arrangement and number of openings 311 is not restricted to those of this embodiment, and they may be appropriately modified in such a manner that the prescribed sections of the bonding pads are exposed.

After patterning, the side of the semiconductor wafer 302 opposite the adhesive layer 301 side is polished to reduce the thickness of the semiconductor wafer 302 to the prescribed thickness (Fig. 12(b)). The polishing is carried out, for example, by attaching a pressure-sensitive adhesive film onto the adhesive layer 301 and fixing the semiconductor wafer 302 on a polishing jig by the pressure-sensitive adhesive film.

After polishing, a composite film 305 comprising a die bonding material 330 and dicing tape 340, laminated together, is attached to the side of the semiconductor wafer 302 opposite the adhesive layer 301 side, oriented with the die bonding material 330 contacting the semiconductor wafer 302. The attachment is carried out with heating if necessary.

Next, the semiconductor wafer 302 is cut, together with the composite film 305, along the dicing lines 390 so that the semiconductor wafer 302 is partitioned into multiple semiconductor elements 320 (Fig. 14(a)). The dicing is accomplished using a dicing blade, for example, while the wafer is completely anchored to a frame by the dicing tape 340.

After dicing, the semiconductor element 320 and the die bonding material 330 attached to its back side are both picked up (Fig. 14(b)). The picked up semiconductor element 320 is mounted on a support base 307 via the die bonding material 330 (Fig. 15(a)).

A second semiconductor element 321 is directly bonded onto the adhesive layer 301 of the semiconductor element 320 that has been mounted on the support base 307 (Fig. 15(b)). In other words, the semiconductor element 320 and the semiconductor element 321 positioned on its upper layer are bonded by the patterned adhesive layer 301 (buffer coat film) lying between them. The semiconductor element 321 is bonded at a position such that the openings 311 of the patterned adhesive layer 301 are not blocked. The patterned adhesive layer 301 (buffer coat film) is also formed on the circuit side of the semiconductor element 321.

Bonding of the semiconductor element 321 is accomplished by, for example, a method of thermocompression bonding while heating to a temperature at which the adhesive layer 301 exhibits fluidity. After thermocompression bonding, the adhesive layer 301 is heated if necessary to further promote curing.

Next, the semiconductor element 320 is connected to an external connecting terminal on the support base 307 via a wire 380 connected to its bonding pad, while the semiconductor element 321 is connected to an external connecting terminal on the support base 307 via a wire 381 connected to its bonding pad. The stack comprising the semiconductor elements is then sealed with a sealing resin layer 360 to obtain a semiconductor device 300 (Fig. 16).

The method for producing a semiconductor device according to this embodiment is not limited to the embodiments described above, and it may incorporate appropriate modifications that still fall within the gist of the invention. For example, the steps of adhesive layer formation and photosensitive film adhesive attachment, dicing, exposure and development and semiconductor wafer polishing may be carried out in a different order as appropriate. As shown in Fig. 17, the semiconductor wafer 302 on which the adhesive layer 301 has been formed may be thinned by polishing and

then diced. In this case, the adhesive layer 301 is patterned by exposure and development after dicing, to obtain a stack similar to that shown in Fig. 14(a). Alternatively, the semiconductor wafer that has been thinned by polishing may be diced first, before formation of the adhesive layer 301 and exposure and development thereof. Also, 3 or more semiconductor elements may be laminated, in which case at least one pair of adjacent semiconductor chips is directly bonded by the patterned photosensitive adhesive (the buffer coat film on the lower layer side).

Figs. 18 to 25 are end views or plan views showing other embodiments of a method for producing a semiconductor device according to the invention. The method for producing a semiconductor device according to this embodiment comprises a step of forming an adhesive layer 407 composed of a photosensitive adhesive composition of the invention on the front side 403a of a glass board 403 having a front side (first main side) 403a and a back side (second main side) 403b which are mutually opposing (Fig. 18 and Fig. 19), a step of exposing the adhesive layer 407 by irradiation of light from the back side 403b side and developing it for patterning of the adhesive layer 407 (Figs. 20 to 22), a step of directly bonding the semiconductor element 405 to the patterned adhesive layer 407 so that the circuit side is facing the glass board 403 side (Fig. 23), and a step of dicing the mutually bonded glass board 403 and semiconductor element 405 for dicing into multiple semiconductor devices 401 (Fig. 24 and Fig. 25).

On the front side 403a of the glass board 403 shown in Fig. 18 there is provided an adhesive layer 407 composed of a photosensitive adhesive composition of the invention (Fig. 19). According to this embodiment, it is convenient to employ a method in which a photosensitive film adhesive obtained by pre-forming the photosensitive adhesive composition of the invention into a film is prepared and attached to the glass board 403.

The adhesive layer 407 composed of the photosensitive adhesive composition of the invention may function as a negative type photosensitive adhesive capable of alkali development, and for bonding of a semiconductor element, can form an adhesive pattern with low variation in film thickness even when a high-definition adhesive pattern has been formed by dissolving development. This will allow high-yield production of a semiconductor device with excellent reliability.

A mask 411 having openings formed at prescribed locations is placed on the back side 403b of the glass board 403, toward the adhesive layer 407 formed on the front side 403a of the glass board 403, and irradiation is performed with active light rays (typically ultraviolet rays) from the back side 403b side, through a mask 411 (Fig. 20). The active light rays thus penetrate the glass board 403 to the adhesive layer 407, and the adhesive layer 407 is photocured and exposed with the prescribed pattern.

Following exposure, the adhesive layer 407 is subjected to dissolving development using an alkali developing solution, thus removing the sections of the adhesive layer 407 that were not exposed, for patterning (Fig. 21). The adhesive layer 407 is formed having a pattern along the sides of approximate square shapes (Fig. 22). The effect of the invention is obtained even if a positive-type photosensitive adhesive is used instead of a negative-type, in which case the sections of the insulating resin layer 207 exposed are removed by development.

The plurality of effective picture element regions 415 formed on the circuit side of the semiconductor element 405 are surrounded by the adhesive layer 407 formed into a pattern along the sides of approximate square shapes, and the semiconductor element 405 is directly bonded to the adhesive layer 407 in such a manner that the circuit side of the semiconductor element 405 faces the glass board 403 side (Fig. 23). The adhesive layer 407 bonds the semiconductor element 405 while also functioning as a spacer to ensure space around the effective picture element regions 415. Bonding of the semiconductor element 405 is accomplished by, for example, a method of thermocompression bonding while heating to a temperature at which the adhesive layer 407 exhibits fluidity. After thermocompression bonding, the adhesive layer 407 is heated if necessary to further promote curing.

After the semiconductor element 405 has been bonded, it is diced along the dashed lines D (Fig. 24) to obtain a plurality of semiconductor devices 401 as shown in Fig. 25. In this case, a dicing film is attached to the side opposite the circuit side of the semiconductor element 405, and the glass board 403 and semiconductor element 405 are cut together with the dicing film to obtain a plurality of semiconductor devices 401. The dicing is accomplished using a dicing blade, for example, while the element is completely anchored to a frame by the dicing film.

The semiconductor device 401 can be suitably used for production of electronic components such as CMOS sensors or CCD sensors. Fig. 26 is an end view showing a CMOS sensor employing a semiconductor device produced by the method for producing a semiconductor device according to the invention. The CMOS sensor 430 is an electronic component provided with a semiconductor device 401 as a solid pickup element. The semiconductor device 401 is electrically connected to a connecting terminal (not shown) on a semiconductor element-mounting support base 434 via a plurality of conductive bumps 432. Instead of a construction in which the semiconductor device 401 is bonded via conductive bumps 432, it may have a construction wherein the semiconductor device 401 is connected to connecting terminals on the semiconductor element-mounting support base 434 via conductive wires.

The CMOS sensor 430 has a construction wherein a lens 438 provided at a location directly over the effective picture element region 415, side walls 440 provided so as to enclose the semiconductor device 401 with the lens 43 8, and a fitting member 442 lying between the lens 438 and side walls 440, in which the lens 438 is fitted, are mounted on the semiconductor element-mounting support base 434.

The CMOS sensor 430 is produced by first producing a semiconductor device 401 as described above, and

then connecting the semiconductor device 401 and semiconductor element 405 with the connecting terminal on the semiconductor element-mounting support base 434 via the conductive bumps 432, and forming a lens 438, side walls 440 and a fitting member 442 on the semiconductor element-mounting support base 434, enclosing the semiconductor device 401.

Since the photosensitive adhesive composition of the invention is capable of dissolving development, it allows high-definition pattern formation with minimal development residue. Consequently, with an image sensor or the like as described above, fabricated using a photosensitive adhesive composition of the invention, adhesion of residual matter or development residue on the effective picture element region is prevented, and defects can be adequately reduced.

## Examples

The present invention will now be explained in detail by examples, with the understanding that the invention is not limited to the examples.

The starting materials listed in Table 1 were used to prepare polyimide resins PI-1 to PI-5.

[Table 1]

| | PI-1 | PI-2 | PI-3 | PI-4 | PI-5 |
|---|---|---|---|---|---|
| Mono functional acid anhydride | TAA | TAA | TAA | - | - |
| Tetracarboxylic dianhydride | ODPA | ODPA | ODPA | ODPA | ODPA |
| Carboxyl group- containing diamine | MBAA | MBAA | MBAA | MBAA | MBAA |
| Diamine with propylene ether skeleton | D-400 | D-400 | D-400 | D-400 | D-400 |
| Diamine with ether skeleton | - | - | B-12 | - | B-12 |
| Diamine with siloxane skeleton | BY16-871EG | BY16-871EG | BY16-871EG | - | BY16-871EG |

The compound names in Table 1 are as follows.
D-400: Polyetherdiamine by BASF (molecular weight: 452.4)
BY16-871EG: 1,3-bis(3-Aminopropyl)tetramethyldisiloxane by Dow Coming Toray (molecular weight: 248.51)
MBAA: 5,5'-Methylene-bis(anthranilic acid) by Wakayama Seika (molecular weight: 286.3)
ODPA: 4,4'-Oxydiphthalic dianhydride by Manac, Inc. (molecular weight: 326.2).
TAA: Trimellitic anhydride by Mitsubishi Gas Chemical Co., Inc. (molecular weight: 192.1).
B-12: 1,4-Butanediol-bis(3-aminopropyl)ether by Tokyo Chemical Industry Co., Ltd. (molecular weight: 204.31)

<PI-1>

In a 300 mL flask equipped with a thermometer, stirrer, condenser tube and nitrogen inflow tube there was stirred a reaction mixture containing 27.1 g (0.06 mol) of D-400, 2.48 g (0.01 mol) of BY16-871EG, 8.58 g (0.03 mol) of MBAA and 113 g of N-methyl-2-pyrrolidone (NMP). After the diamine dissolved, 32.62 g (0.1 mol) of ODPA and 5.76 g (0.03 mol) of TAA were added in small portions at a time. This was stirred for 8 hours at room temperature, and then 75.5 g of xylene was added and the mixture was heated at 180°C while blowing in nitrogen gas to azeotropically remove the xylene with water to obtain a polyimide resin (PI-1) varnish. The weight-average molecular weight Mw of the obtained polyimide resin was measured by GPC to be 25000 based on polystyrene.

<PI-2>

In a 300 mL flask equipped with a thermometer, stirrer, condenser tube and nitrogen inflow tube there was stirred a reaction mixture containing 31.6 g (0.07 mol) of D-400, 4.97 g (0.02 mol) of BY16-871EG, 2.86 g (0.01 mol) of MBAA and 102 g of N-methyl-2-pyrrolidone. After the diamine dissolved, 32.62 g (0.1 mol) of ODPA and 5.76 g (0.03 mol) of TAA were added in small portions at a time. After reaction for 8 hours at room temperature, 75.5 g of xylene was added, and the mixture was heated at 180°C while blowing in nitrogen gas to azeotropically remove the xylene with water to obtain a polyimide resin (PI-2) varnish. The weight-average molecular weight Mw of the obtained polyimide resin was measured by GPC to be 22000 based on polystyrene.

<PI-3>

In a 300 mL flask equipped with a thermometer, stirrer, condenser tube and nitrogen inflow tube there was stirred a reaction mixture containing 8.17 g (0.04 mol) of B-12, 13.57 g (0.03 mol) of D-400, 2.48 g (0.01 mol) of BY16-871EG, 5.72 g (0.02 mol) of MBAA and 110 g of N-methyl-2-pyrrolidone. After the diamine dissolved, 29.35 g (0.09 mol) of ODPA and 3.84 g (0.02 mol) of TAA were added in small portions at a time. After reaction for 8 hours at room temperature, 70.5 g of xylene was added, and the mixture was heated at 180°C while blowing in nitrogen gas to azeotropically remove the xylene with water to obtain a polyimide resin (PI-3) varnish. The weight-average molecular weight Mw of the obtained polyimide resin was measured by GPC to be 21000 based on polystyrene.

<PI-4>

In a 300 mL flask equipped with a thermometer, stirrer, condenser tube and nitrogen inflow tube there was stirred a reaction mixture containing 22.62 g (0.05 mol) of D-400, 11.45 g (0.04 mol) of MBAA and 90 g of N-methyl-2-pyrrolidone. After the diamine dissolved, 32.62 g of ODPA was added in small portions at a time. After reaction for 8 hours at room temperature, 60.5 g of xylene was added, and the mixture was heated at 180°C while blowing in nitrogen gas to azeotropically remove the xylene with water to obtain a polyimide resin (PI-4) varnish. The weight-average molecular weight Mw of the obtained polyimide resin was measured by GPC to be 33000 based on polystyrene.

<PI-5>

In a 300 mL flask equipped with a thermometer, stirrer, condenser tube and nitrogen inflow tube there was stirred a reaction mixture containing 2.04 g (0.01 mol) of B-12, 27.14 g (0.06 mol) of D-400, 2.48 g (0.01 mol) ofBY16-871EG, 2.86 g (0.01 mol) OF MBAA and 110 g of N-methyl-2-pyrrolidone. After the diamine dissolved, 32.62 g (0.1 mol) of ODPA was added in small portions at a time. After reaction for 8 hours at room temperature, 75.5 g of xylene was added, and the mixture was heated at 180°C while blowing in nitrogen gas to azeotropically remove the xylene with water to obtain a polyimide resin (PI-5) varnish. The weight-average molecular weight Mw of the obtained polyimide resin was measured by GPC to be 30000 based on polystyrene.

(Examples 1-5, Comparative Examples 1-4)

Each of the obtained polyimide varnishes (PI-1 to PI-5) were used for mixing of the components in the compositional ratios listed in Table 1 and Table 2 (units: parts by weight), to obtain photosensitive adhesive compositions (adhesive layer-forming varnishes).

[Table 2]

| | | Example | | | | |
|---|---|---|---|---|---|---|
| | | 1 | 2 | 3 | 4 | 5 |
| Base polymer | PI-1 | - | - | 100 | - | - |
| | PI-2 | - | - | - | 100 | - |
| | PI-3 | 100 | 100 | - | - | 100 |
| Radmtion-polymerizable compound | BPE-100 | - | - | 40 | 40 | 40 |
| | A-9300 | 70 | 70 | 30 | - | - |
| | U-2PPA | - | - | - | 40 | - |
| | M-313 | - | - | - | - | 30 |
| Epoxy resin | VG-3101 | 5 | 5 | 5 | 5 | 5 |
| | YDF-8170 | 30 | 10 | 10 | 10 | 10 |
| Curing agent | TrisP-PA | 10 | 5 | 5 | 5 | 5 |
| Filler | R-972 | - | - | 30 | 30 | 30 |

(continued)

| | | Example | | | | |
|---|---|---|---|---|---|---|
| | | 1 | 2 | 3 | 4 | 5 |
| Photoinitiator | I-819 | - | 1 | 3 | 3 | 3 |
| | I-OXE02 | 3 | 2 | - | - | - |
| Thermal radical generator | PERCUMYLD | - | - | 2 | 2 | 2 |

[Table 3]

| | | Comp. Ex. | | | |
|---|---|---|---|---|---|
| | | 1 | 2 | 3 | 4 |
| Base polymer | PI-4 | - | 100 | - | - |
| | PI-5 | 100 | - | 100 | 100 |
| Radiation-polymerizable compound | BPE-100 | 40 | 40 | 40 | 40 |
| | A-9300 | 30 | 30 | - | - |
| | U-2PPA | - | - | 40 | - |
| | M-313 | - | - | - | 30 |
| Epoxy resin | VG-3101 1 | 5 | 5 | 5 | 5 |
| | YDF-8170 | 10 | 10 | 10 | 10 |
| Curing agent | TrisP-PA | 5 | 5 | 5 | 5 |
| Filter | R-972 | - | 30 | 30 | 30 |
| Photoinitiator | I-819 | 3 | 3 | 3 | 3 |
| Thermal radical generator | PERCLTMYL D | 2 | 2 | 2 | 2 |

The compound names in Table 2 and Table 3 are as follows.
BPE-100: Ethoxylated bisphenol A dimethacrylate by Shin-Nakamura Chemical Co., Ltd.
A-9300: Isocyanuric acid EO-modified triacrylate by Shin-Nakamura Chemical Co., Ltd.
U-2PPA: Bifunctional urethane acrylate by Shin-Nakamura Chemical Co., Ltd.
M-313: Isocyanuric acid EO-modified acrylate by ToaGosei Co., Ltd.
VG-3101: Trifunctional epoxy resin by Printec.
YDF-8170: Bisphenol F bisglycidyl ether by Tohto Kasei Co., Ltd.
TrisP-PA: Trisphenol compound ($\alpha,\alpha,\alpha'$-tris(4-hydroxyphenol)-1-ethyl-4-isopropylbenzene) by Honshu Chemical Industry Co., Ltd.
R-972: Hydrophobic fumed silica (mean particle size: approximately 16 nm) by Nippon Aerosil Co., Ltd.
I-819: bis(2,4,6-Trimethylbenzoyl)-phenylphosphine oxide by Ciba, Japan.
I-OXE02:

Ethanone-1-[9-ethyl-6-(2-methylbenzoyl)-9H-carbazol-3-yl]-1-(O-acetyloxime), oxime ester group-containing compound by Ciba, Japan

PERCUMYL D: Dicumyl peroxide by NOF Corp. (1 minute half-life temperature: 175°C).

For Example 1, Example 2 and Comparative Example 1, each material was dissolved in NMP to a Nv (nonvolatile portion) of 30%. For the other examples and comparative examples (Examples 3-5, Comparative Examples 2-4), each adhesive layer-forming varnish was coated as a film on a base (PET film) to a post-drying thickness of 50 $\mu$m, to obtain a film-like adhesive sheet. These were evaluated for various properties in the following manner.

<Confirmation of developing mode>

Each of the varnishes obtained in Example 1, Example 2 and Comparative Example 1 was spin coated (product of Mikasa, conditions: 400 rpm for 10 seconds followed by 700 rpm for 30 seconds) onto the back side (the side opposite the support stage side) of a silicon wafer (6-inch diameter, 400 μm thickness) that had been placed on a support stage, and was then pre-baked at 100°C for 5 minutes to form a 3 μm-thick film. Separately, each of the film-like adhesive sheets obtained in Examples 3-5 and Comparative Examples 2-4 was laminated onto the back side of a silicon wafer (6-inch diameter, 400 μm thickness) that had been placed on a support stage (the side opposite the support stage side), orienting the adhesive layer toward the silicon wafer side and pressing with a roll (temperature: 70°C, linear pressure: 4 kgf/cm, feed rate: 0.5 m/min).

Next, a negative pattern mask ("No.G-2" (trade name, pattern width: 200 μm) by Hitachi Chemical Co., Ltd. was used for Example 1, Example 2 and Comparative Example 1 and Photomask A having a 1 mm-wide drawn pattern (see Fig. 29) was used for Examples 3-5 and Comparative Examples 2-4) was placed on the film of each of the sheets having films formed by spin coating (Example 1, Example 2 and Comparative Example 1) and on the base of each of the laminated adhesive sheets (Examples 3-5 and Comparative Examples 2-4), and ultraviolet rays were emitted from a high-precision parallel exposure apparatus ("EXM-1172-B-∞", trade name of Orc Manufacturing Co., Ltd.), using a "AHD-3000-M-F-N" ultraviolet irradiation lamp emitting ultraviolet rays of 200 nm or greater as the light source for exposure with a cumulative exposure dose of 1000 $mJ/cm^2$, obtained with a "UV-SN35" spectrometer having a peak at 365 nm, after which each sheet was allowed to stand for about 30 seconds on a hot plate at 80°C.

Next, for Example 1, Example 2 and Comparative Example 1, it was dipped for 10 seconds in a photograph vat at room temperature, using a 2.38 wt% aqueous solution of tetramethylammonium hydride (TMAH) as the developing solution, and then a spin developer (product of NoaCraft, Ltd.) was used for spray washing for 30 seconds at a rotational speed of 3000 rpm and a pressure of 0.1 MPa. For Examples 3-5 and Comparative Examples 2-4, the base was removed from the film-like adhesive sheet and a spin developer (product of NoaCraft, Ltd.) was used for spraying of 2.38% TMAH for 30 seconds at 3000 rpm and a pressure of 0.5 MPa, followed by spray washing for 60 seconds at 3000 rpm and a pressure of 0.5 MPa.

The formed pattern was then observed by SEM (product of Hitachi, Ltd.). The obtained SEM photographs are shown in Fig. 27. Those without observable development residue (700 in Fig. 27) were evaluated as dissolving development mode "A", and those with observable development residue were evaluated as flaking developing mode "C". The term "without observable development residue" means that the width of residue on the unexposed sections remaining without dissolution is no greater than 1/20 of the pattern width, and the term "with observable development residue" means that the width of residue on the unexposed sections remaining without dissolution is greater than 1/20 of the pattern width. The results are shown in Table 4 and Table 5.

<Measurement of residue rate of adhesive pattern film thickness)>

Each of the varnishes obtained in Examples 1 and 2 and Comparative Example 1 was spin coated (product of Mikasa, conditions: 400 rpm for 10 seconds followed by 700 rpm for 30 seconds) onto the back side (the side opposite the support stage side) of a silicon wafer (6-inch diameter, 400 μm thickness) that had been placed on a support stage, and was then pre-baked at 100°C for 5 minutes to form a 3 μm-thick film. Separately, each of the film-like adhesive sheets obtained in Examples 3-5 and Comparative Examples 2-4 was laminated onto the back side of a silicon wafer (6-inch diameter, 400 μm thickness) that had been placed on a support stage (the side opposite the support stage side), orienting the adhesive layer toward the silicon wafer side and pressing with a roll (temperature: 70°C, linear pressure: 4 kgf/cm, feed rate: 0.5 m/min).

Next, a negative pattern mask ("No.G-2" (trade name, pattern width: 200 μm) by Hitachi Chemical Co., Ltd. was used for Example 1, Example 2 and Comparative Example 1 and Photomask A having a 1 mm-wide drawn pattern (see Fig. 29) was used for Examples 3-5 and Comparative Examples 2-4) was placed on the film of each of the sheets having films formed by spin coating (Example 1, Example 2 and Comparative Example 1) and on the base (PET film) of each of the laminated adhesive sheets (Examples 3-5 and Comparative Examples 2-4), and ultraviolet rays were emitted from a high-precision parallel exposure apparatus ("EXM-1172-B-∞", trade name of Orc Manufacturing Co., Ltd.), using a "AHD-3000-M-F-N" ultraviolet irradiation lamp emitting ultraviolet rays of 200 nm or longer as the light source for exposure to a cumulative exposure dose of 1000 $mJ/cm^2$, obtained with a "UV-SN35" spectrometer having a peak at 365 nm, after which each sheet was allowed to stand for about 30 seconds on a hot plate at 80°C.

Next, for Examples 3-5 and Comparative Examples 2-4, the base film was removed and a surface roughness meter ("SE-2300" by Kosaka Laboratory, Ltd.) was used to measure the film thickness of the adhesive layer before development. The film thickness was recorded as $T_0$.

Next, for Example 1, Example 2 and Comparative Example 1, it was dipped for 10 seconds in a photograph vat at room temperature, using a 2.38 wt% aqueous solution of tetramethylammonium hydride (TMAH) as the developing

solution, and then a spin developer (NoaCraft, Ltd.) was used for spray washing for 30 seconds at a rotational speed of 3000 rpm and a pressure of 0.1 MPa. For Examples 3-5 and Comparative Examples 2-4, the base was removed from the film-like adhesive sheet and a spin developer (product of NoaCraft, Ltd.) was used for spraying of 2.38% TMAH for 30 seconds at 3000 rpm and a pressure of 0.5 MPa, followed by spray washing for 60 seconds at 3000 rpm and a pressure of 0.5 MPa. Pattern formation was followed by washing for 3 minutes with pure water at a temperature of 25°C.

After then removing the water droplets adhering to the front side of the adhesive pattern, a surface roughness meter was used to measure the film thickness of the adhesive pattern, and the film thickness was recorded as $T_1$. The film residue rate was determined based on the formula $(T_1/T_0) \times 100$. Examples with a film residue rate of 90% or greater were evaluated as "A", and those with less than 90% were evaluated as "C". The results are shown in Table 4 and Table 5.

<Evaluation of adhesion>

Each of the varnishes obtained in Example 1, Example 2 and Comparative Example 1 was spin coated (product of Mikasa, conditions: 400 rpm for 10 seconds followed by 700 rpm for 30 seconds) onto a silicon wafer (6-inch diameter, 400 μm thickness), and then pre-baked at 100°C for 5 minutes to form a 3 μm-thick film. Separately, each of the film-like adhesive sheets obtained in Examples 3-5 and Comparative Examples 2-4 was laminated onto a silicon wafer (6-inch diameter, 400 μm thickness), orienting the adhesive layer toward the silicon wafer side and pressing with a roll (temperature: 70°C, linear pressure: 4 kgf/cm, feed rate: 0.5 m/min).

Next, ultraviolet rays were irradiated onto each of the obtained stacks with a high-precision parallel exposure apparatus, using an "AHD-3000-M-F-N" ultraviolet irradiation lamp emitting ultraviolet rays of 200 nm or greater as the light source for exposure with a cumulative exposure dose of 1000 mJ/cm$^2$, obtained with a "UV-SN35" spectrometer having a peak at 365 nm, after which each article was allowed to stand for about 30 seconds on a hot plate at 80°C. Next, for Examples 3-5 and Comparative Examples 2-4, the stack from which the base film had been removed was dipped in a 2.38 wt% TMAH aqueous solution under conditions of 26°C, 3 min, and then washed for 3 minutes with purified water at a temperature of 25°C. The obtained adhesive-attached wafer was dried at 150°C for 1 minute and a dicer was used for individuation to sizes of 3 mm × 3 mm.

The individuated adhesive layer-attached silicon wafer was dried at 120°C for 10 minutes and then placed on a glass board (10 mm × 10 mm × 0.55 mm) with the adhesive layer on the glass board side, and contact bonded at a pressure of 2 kgf and a temperature of 150°C. The obtained test piece was heat cured in an oven at 180°C for 3 hours. The adhesive force of the test piece was then measured using a "Dage-4000" shear adhesion tester. Pieces with measured values of 5 MPa and greater were evaluated as "A", and those of less than 5 MPa were evaluated as "C". The results are shown in Table 4 and Table 5.

[Table 4]

| | Example 1 | Example 2 | Example 3 | Example 4 | Example 5 |
|---|---|---|---|---|---|
| Developing mode | A (No residue) Fig. 27(a) | A (No residue) Fig. 27(b) | A (No residue) Fig. 27(c) | A (No residue) Fig. 27(d) | A (No residue) Fig. 27(e) |
| Film residue rate | A | A | A | A | A |
| Shear adhesive force | A | A | A | A | A |

[Table 5]

| | Comp. Example 1 | Comp. Example 2 | Comp. Example 3 | Comp. Example 4 |
|---|---|---|---|---|
| Developing mode | C (Residue) Fig. 27(f) | C (Residue) Fig. 27(g) | C (Residue) Fig. 27(h) | C (Residue) Fig. 27(i) |
| Film residue rate | A | A | A | A |
| Shear adhesive force | A | A | A | A |

As shown in Table 4, it was confirmed that the photosensitive adhesive compositions of Examples 1-5, which

had solubility and developability and film residue rates of 90% or greater, allowed formation of satisfactory patterns, while also being capable of bonding between adherends with sufficient shear adhesive force.

Explanation of Symbols

1, 301: Photosensitive film adhesives (adhesive layers), 2: cover film, 3: base film (base), 217, 302, 804: semiconductor wafers, 320, 321, 405: semiconductor elements, 380, 381: wires, 360: sealing material, 100, 110: adhesive sheets, 200, 201, 210, 300, 401: semiconductor devices, 203: board (first adherend), 205: semiconductor element (second adherend), 207: insulating resin layer, 209: conductive layer, 211, 325: circuit sides, 213, 311: openings, 215, 303, 411, 900: masks, 305: composite film, 307: support base, 330: die bonding agent, 340: dicing tape, 390: dicing line, 403: glass board, 403a: front side of glass board (first main side), 403b: back side of glass board (second main side), 407: adhesive layer, 415: effective picture element region, 430: CMOS sensor, 432: conductive bump, 434: semiconductor element-mounting support base, 438: lens, 440: side wall, 442: fitting member, 500: exposed section, 600: dissolving developed unexposed section, 700: residue, 801: pattern width of exposed section, 802: width of residue of unexposed section, 803: adhesive layer.

## Claims

1. A photosensitive adhesive composition that can form an adhesive layer on an adherend and allows an adhesive pattern to be formed by exposure treatment with radiation and developing treatment with a developing solution,
   the photosensitive adhesive composition having solubility and developability, and
   the film thickness $T_1$ (μm) of the adhesive pattern formed after development satisfying the conditions represented by the following expression (1).

$$(T_1/T_0) \times 100 \geq 90 \ldots (1)$$

   [In expression (1), $T_0$ represents the film thickness (μm) of the adhesive layer before developing treatment.]

2. The photosensitive adhesive composition according to claim 1, comprising (A) an alkali-soluble resin, (B) a photoinitiator, (C) an epoxy resin and (D) a radiation-polymerizable compound.

3. The photosensitive adhesive composition according to claim 2, wherein the (A) alkali-soluble resin is a polyimide resin or polyamideimide resin.

4. The photosensitive adhesive composition according to claim 3, wherein the polyimide resin or polyamideimide resin is a polymer obtained by reaction between an acid monomer and a diamine monomer,
   the acid monomer comprising a monofunctional acid anhydride and a tetracarboxylic dianhydride.

5. The photosensitive adhesive composition according to claim 4, wherein the diamine monomer comprises a diamine having at least a propylene ether skeleton in the molecule.

6. The photosensitive adhesive composition according to any one of claims 2 to 5, which further comprises (E) a filler.

7. A photosensitive film adhesive comprising the photosensitive adhesive composition according to any one of claims 1 to 6 formed into a film shape.

8. An adhesive pattern that is formed by forming an adhesive layer composed of the photosensitive adhesive composition according to any one of claims 1 to 6 on an adherend, exposing the adhesive layer, and developing the exposed adhesive layer with a developing solution.

9. A semiconductor wafer with an adhesive layer, comprising a semiconductor wafer and an adhesive layer composed of the photosensitive adhesive composition according to any one of claims 1 to 6 formed on one side of the semiconductor wafer.

10. A semiconductor device having a structure wherein a semiconductor element and glass are bonded using the

photosensitive adhesive composition according to any one of claims 1 to 6.

**11.** A semiconductor device having a structure wherein a semiconductor element and a semiconductor element-mounting supporting member or a semiconductor element are bonded using the photosensitive adhesive composition according to any one of claims 1 to 6.

**12.** An electronic component comprising the semiconductor device according to claim 10 or 11.

*Fig.1*

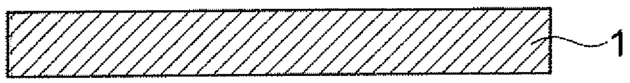

*Fig.2*

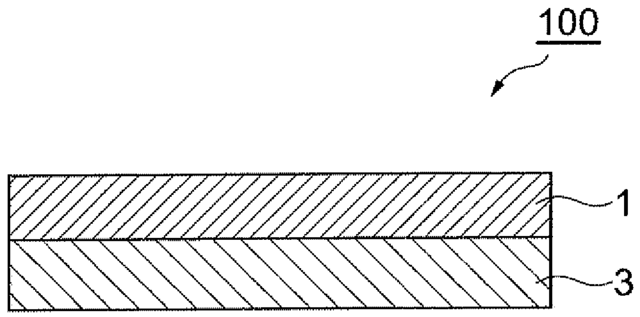

*Fig.3*

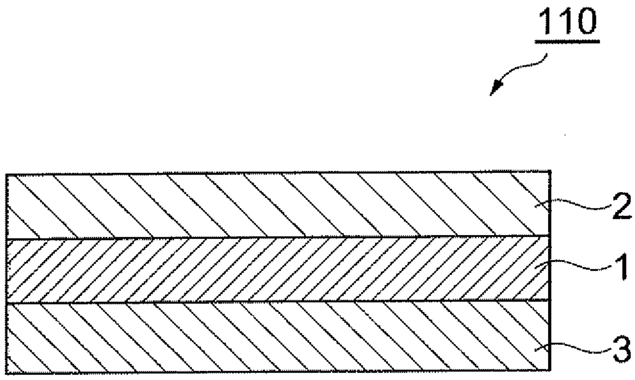

Fig.4

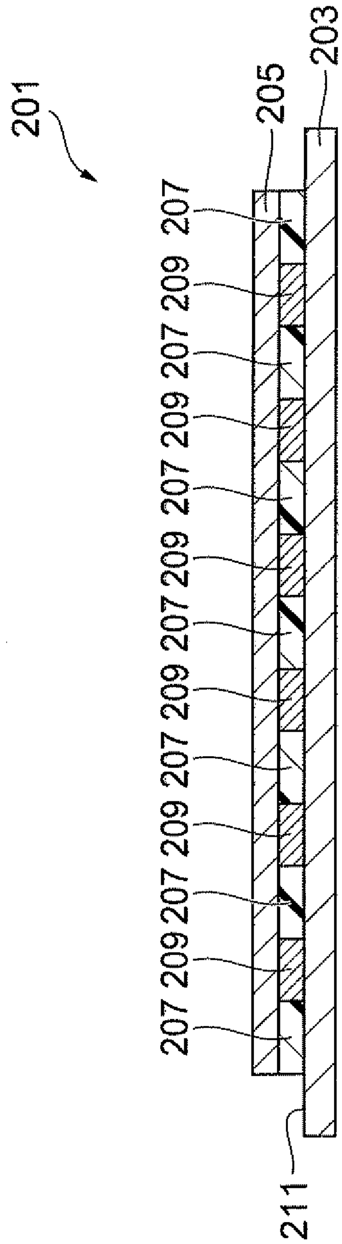

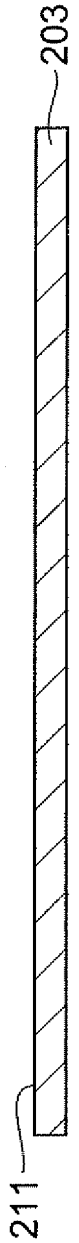


Fig.5

Fig.6

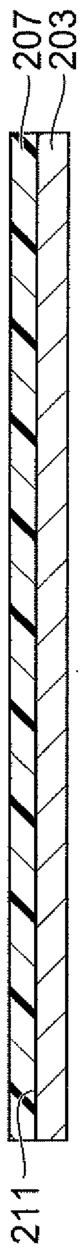

Fig.7

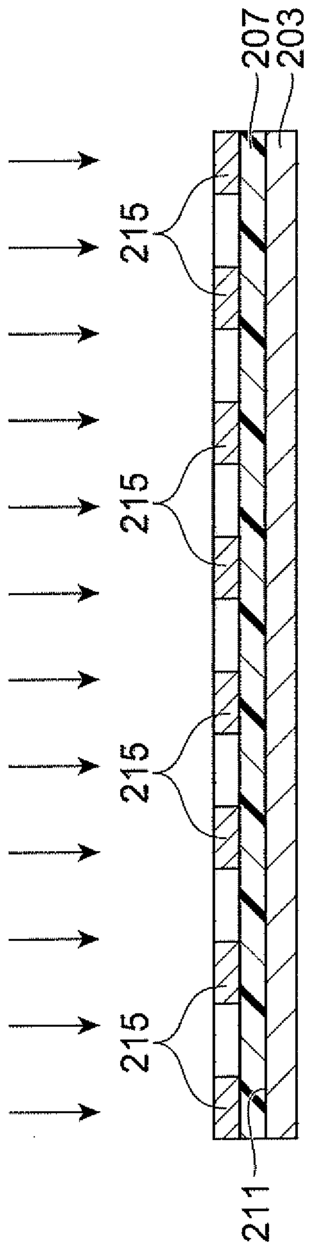

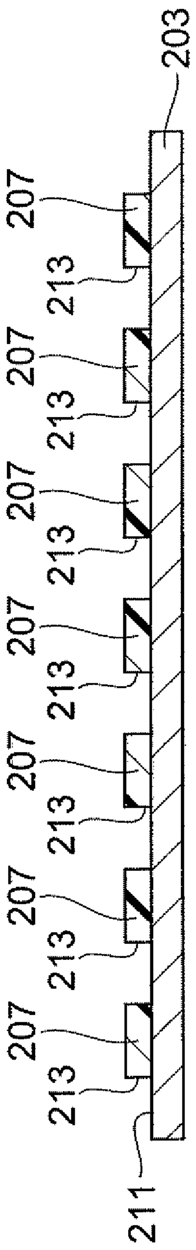


*Fig.8*

Fig.9

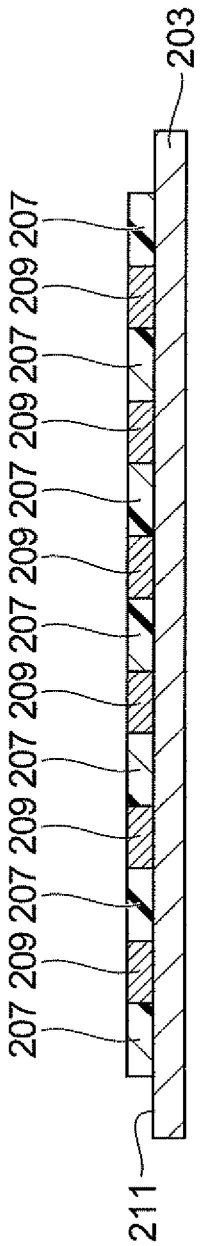
203
207 209 207 209 207 209 207 209 207 209 207 209 207 209 207
211

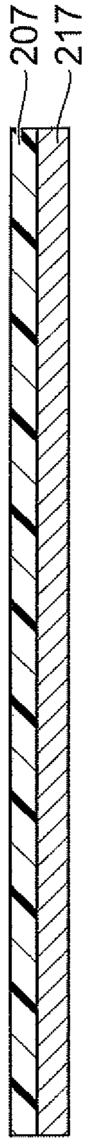


Fig.10

Fig.11

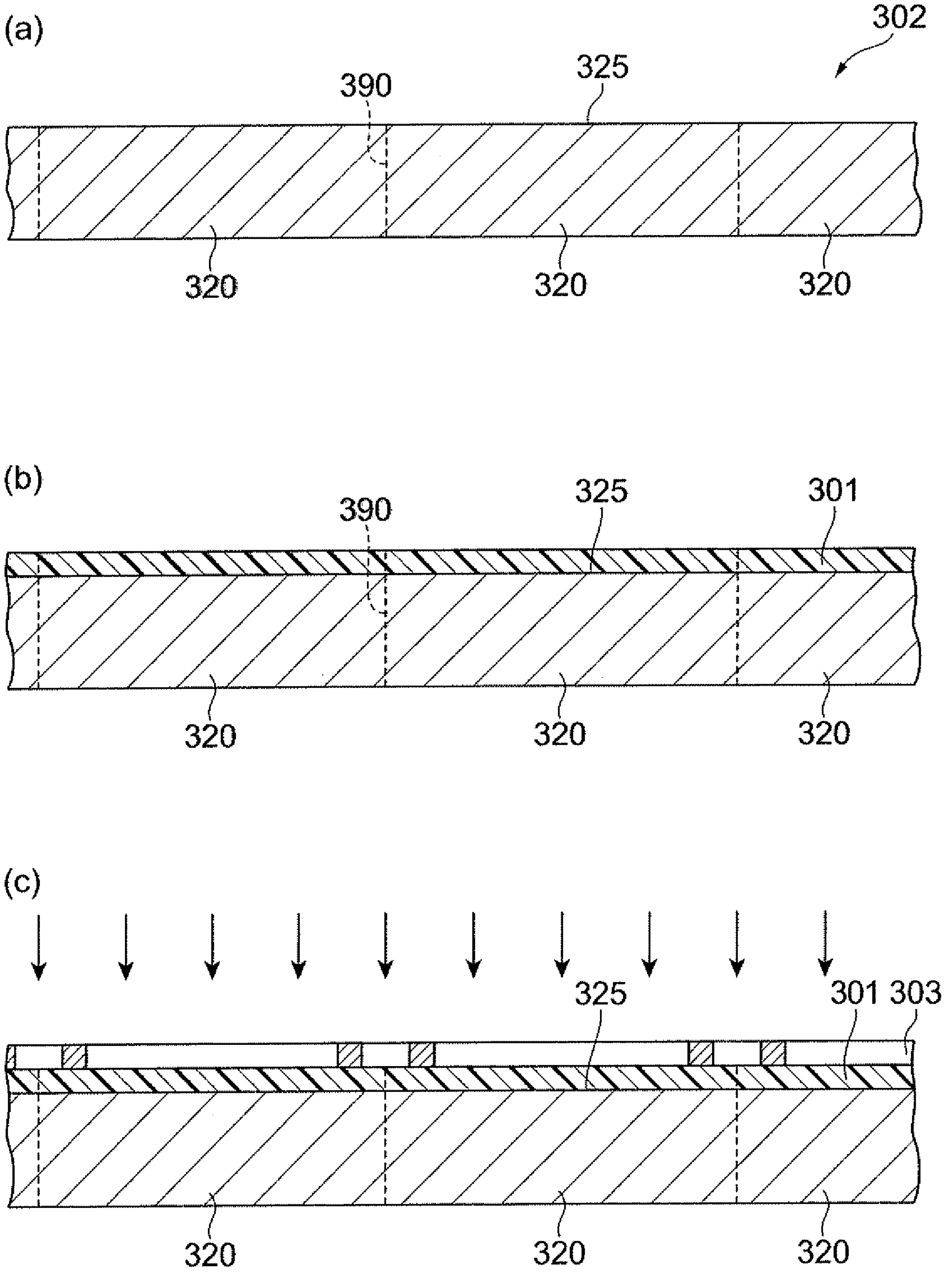
(a)
302
325
390
320
320
320
(b)
390
325
301
320
320
320
(c)
325
301 303
320
320
320

# Fig.12

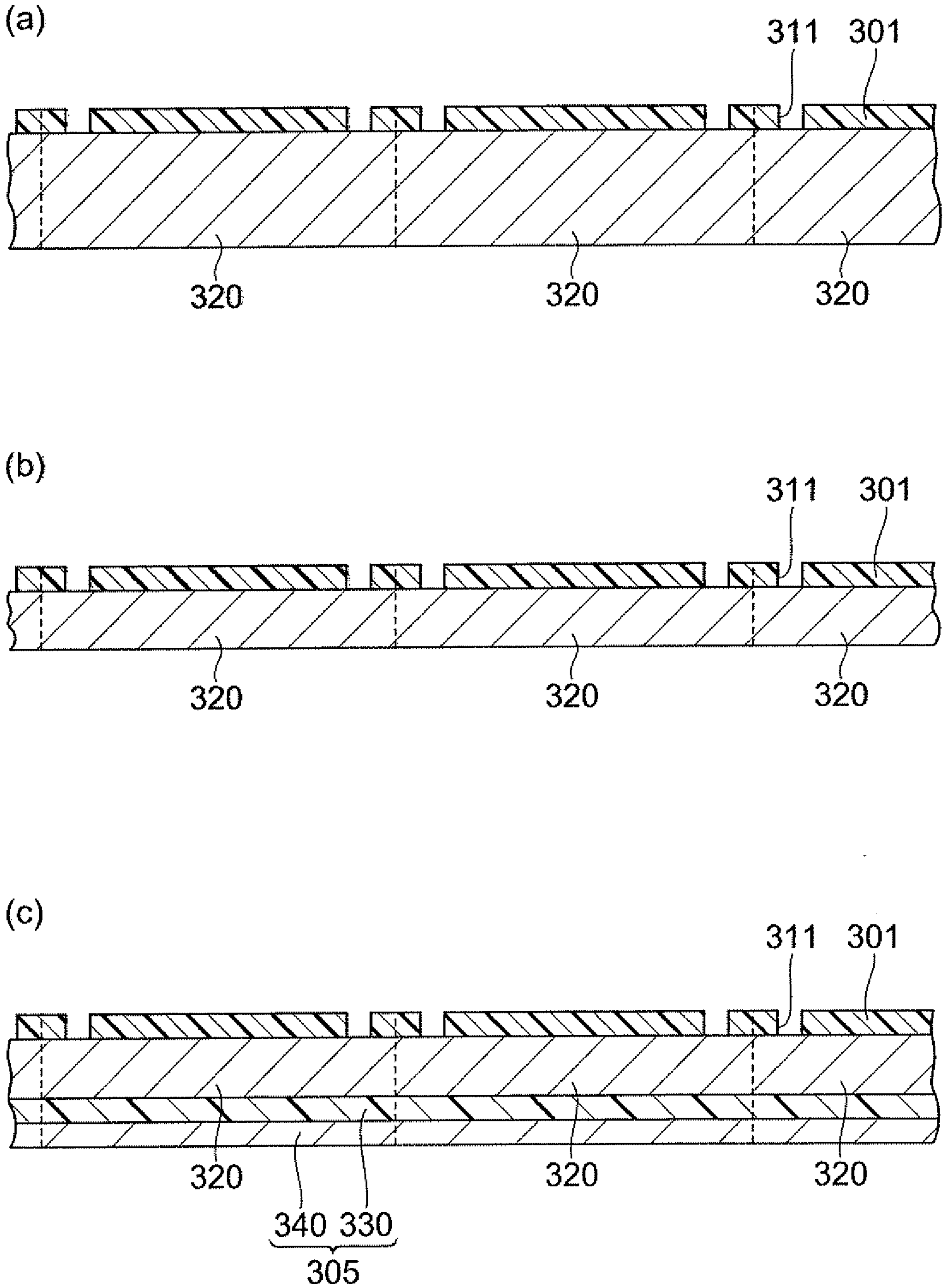
(a)
311
301
320
320
320
(b)
311
301
320
320
320
(c)
311
301
320
320
320
340
330
305

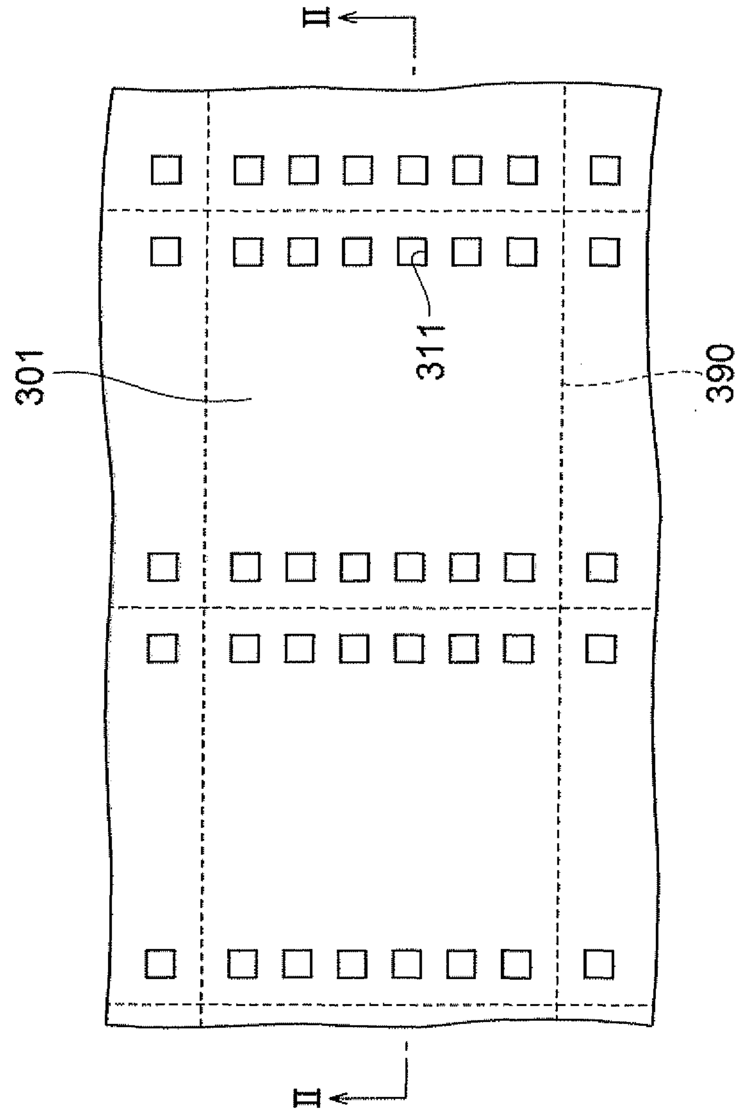


Fig.13

Fig.14

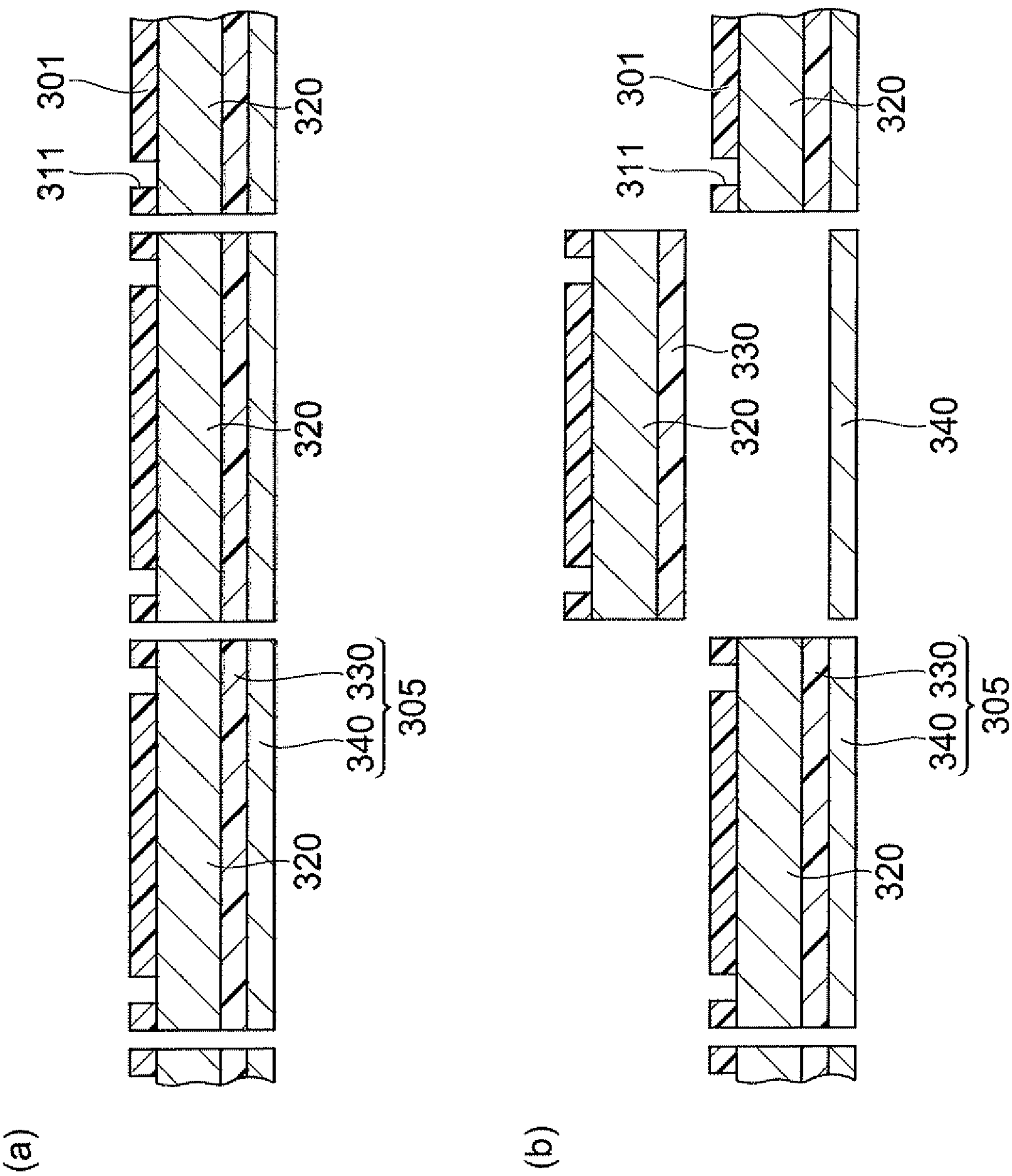
(a)
311
301
320
320
340 330
305
320
(b)
311
301
320
320 330
340
340 330
305
320

*Fig.15*

(a)

(b)

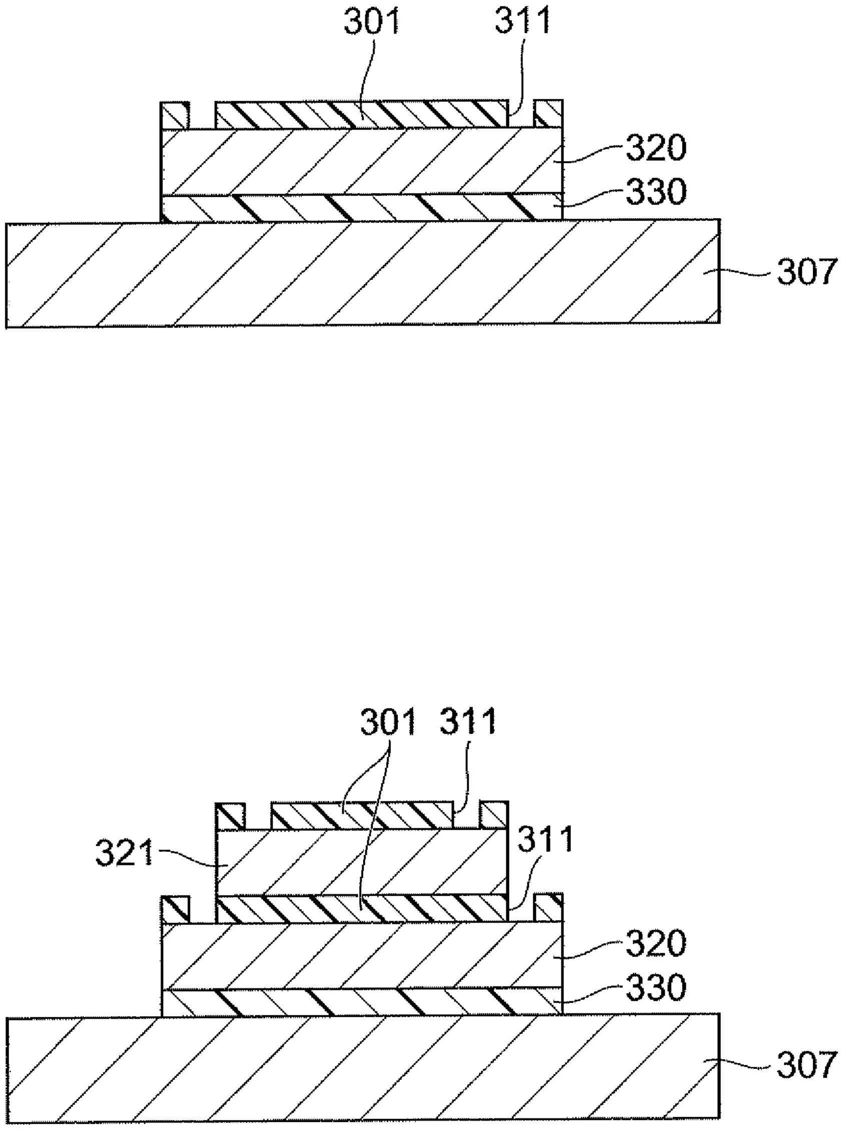

*Fig.16*

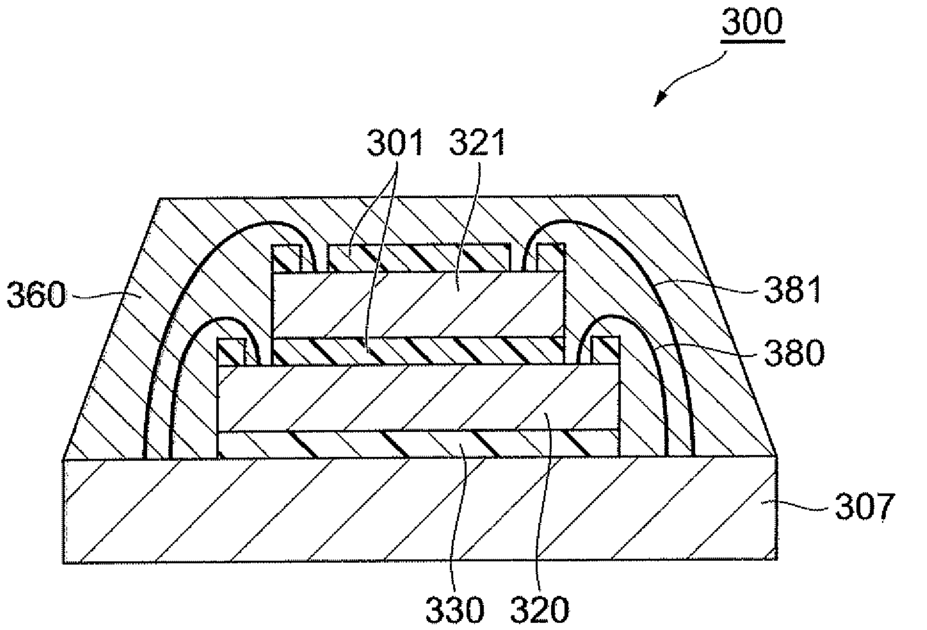

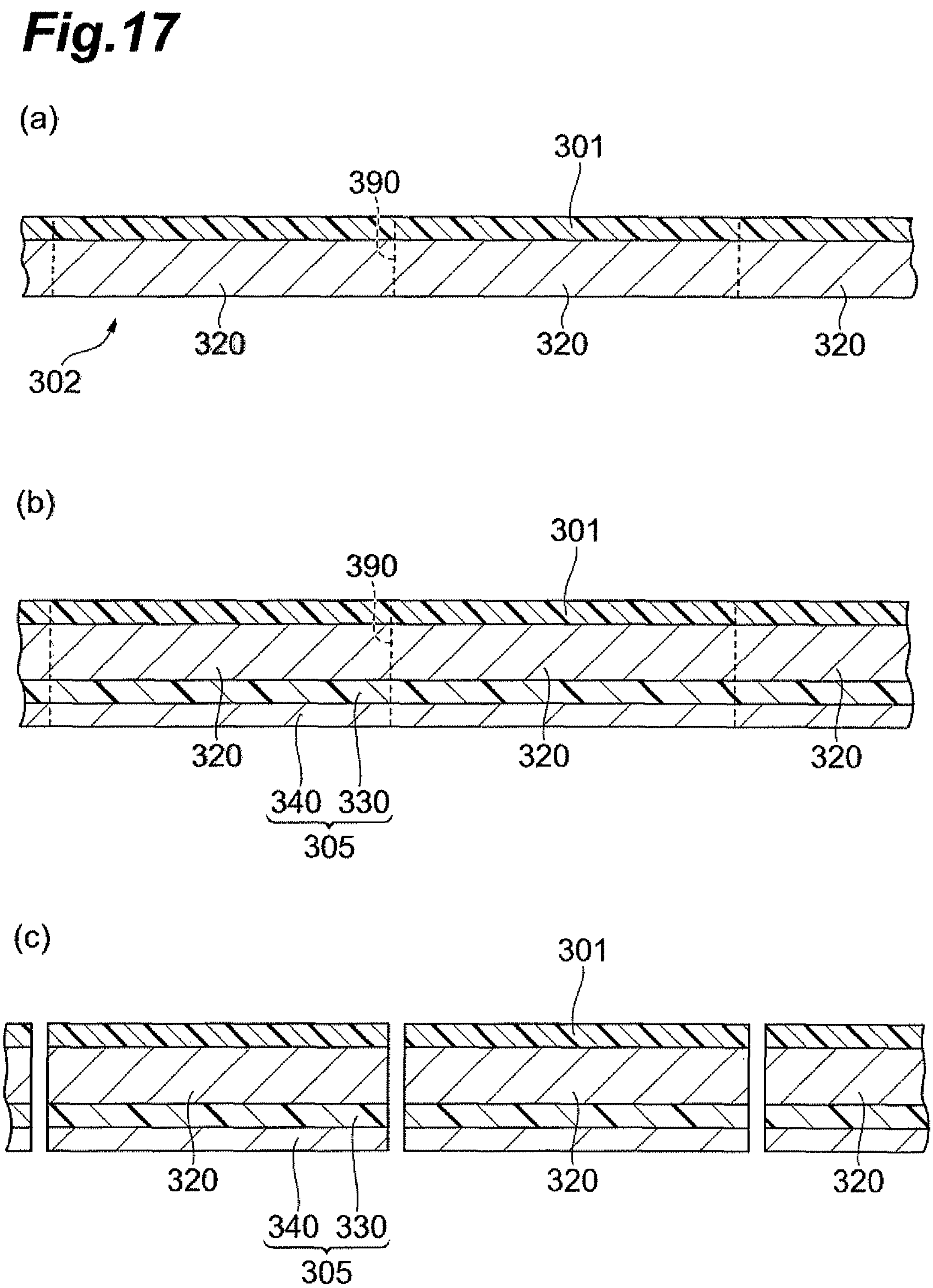
Fig.17
(a)
301
390
320
320
320
302
(b)
301
390
320
320
320
340 330
305
(c)
301
320
320
320
340 330
305

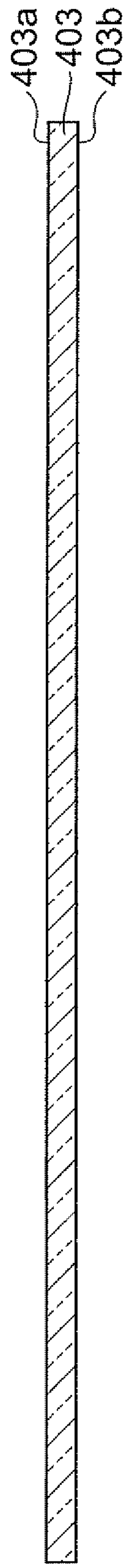


Fig.18

Fig.19

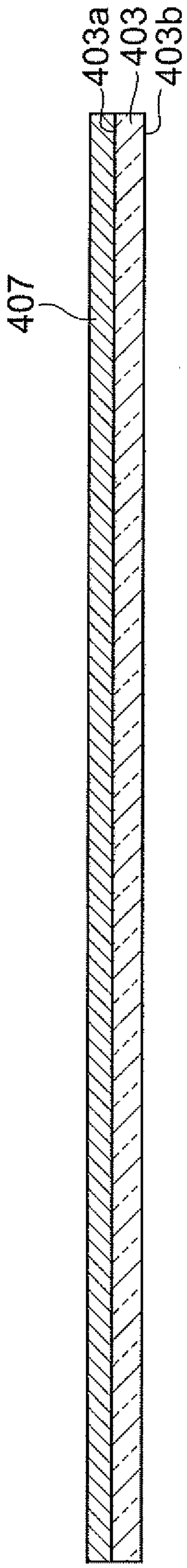

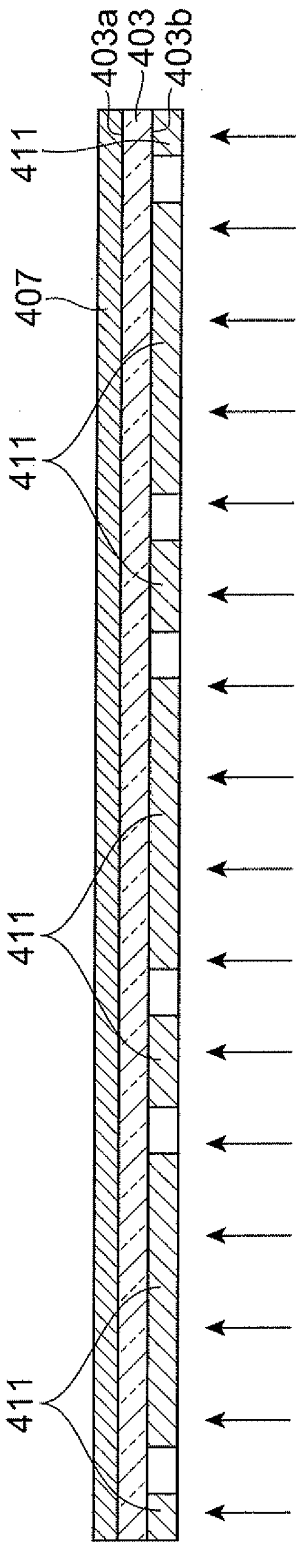


Fig.20

Fig.21

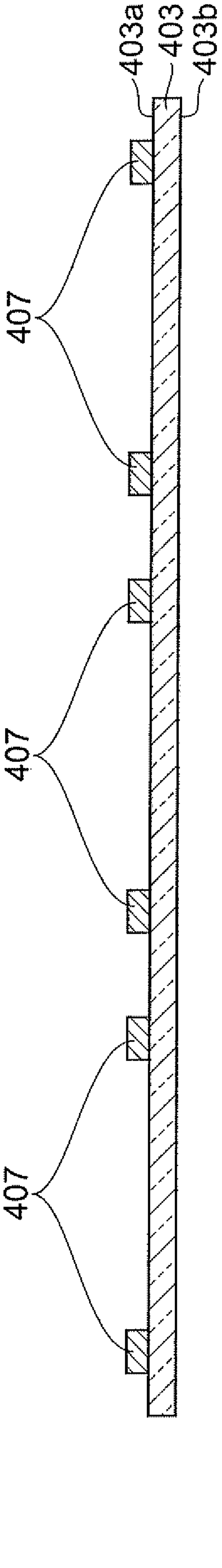

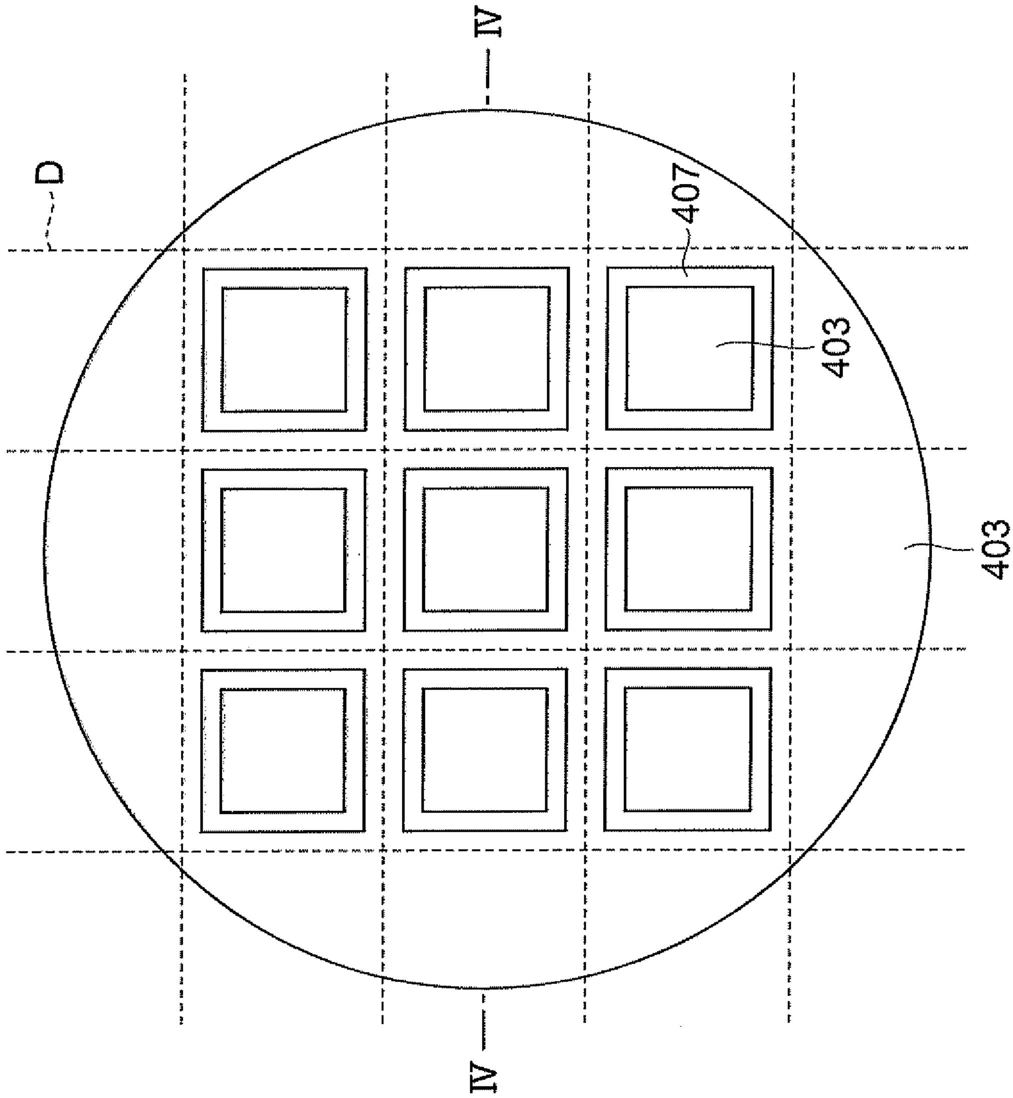


Fig.22

Fig.23

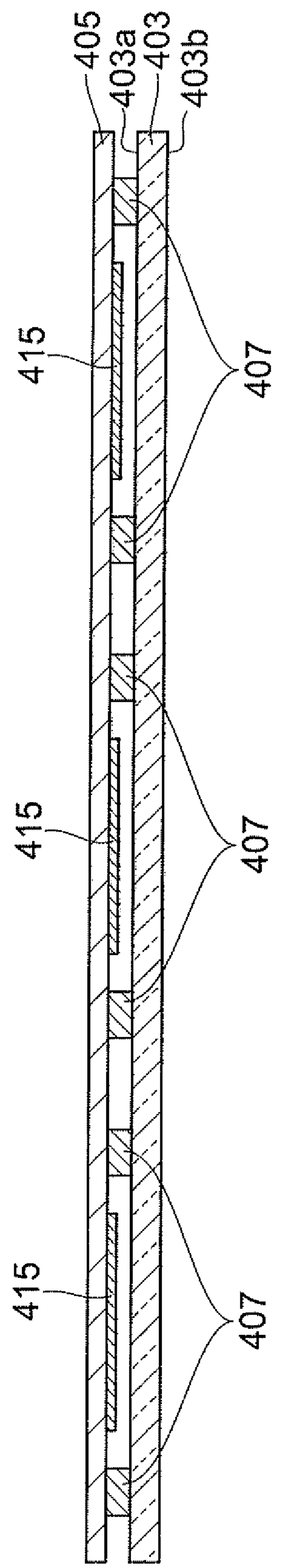

Fig.24

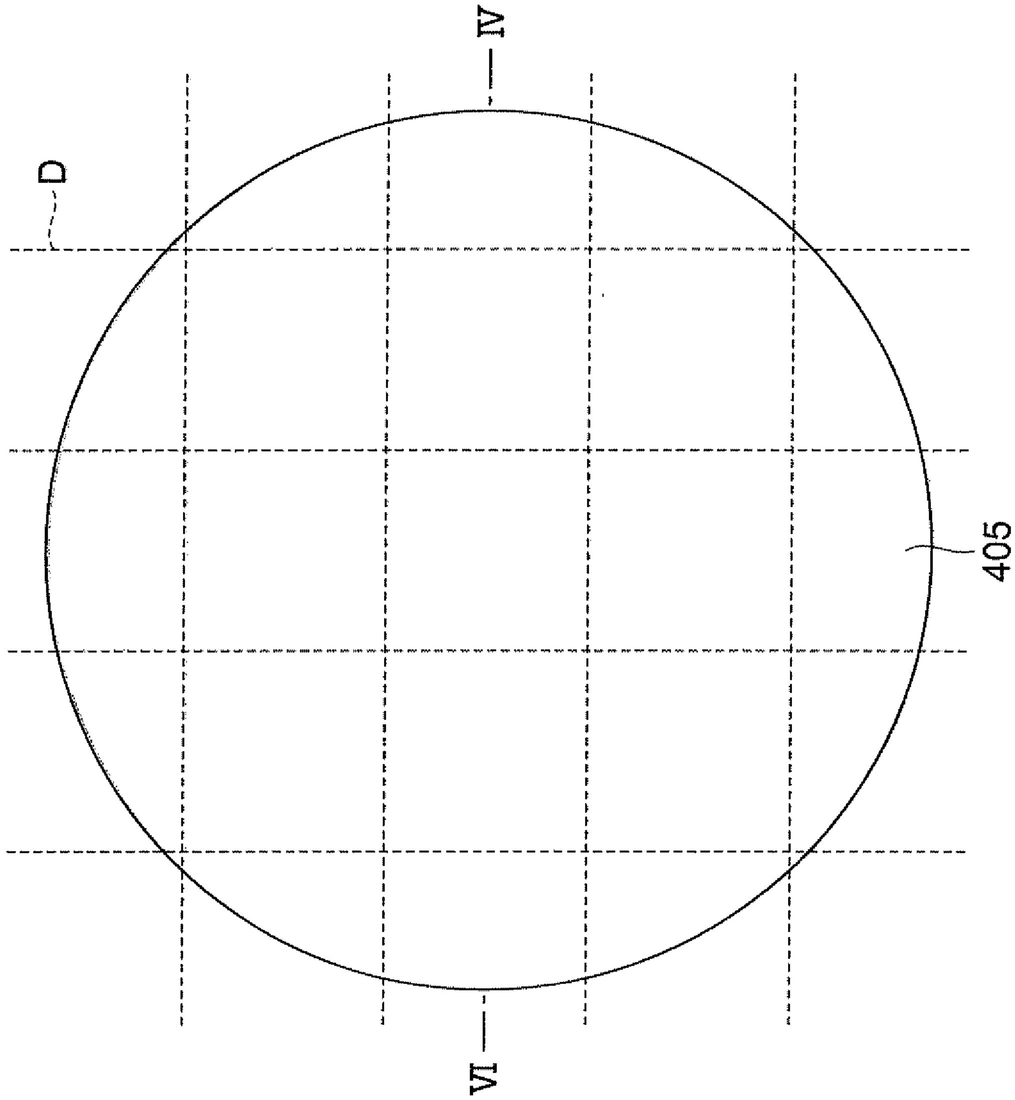

*Fig.25*

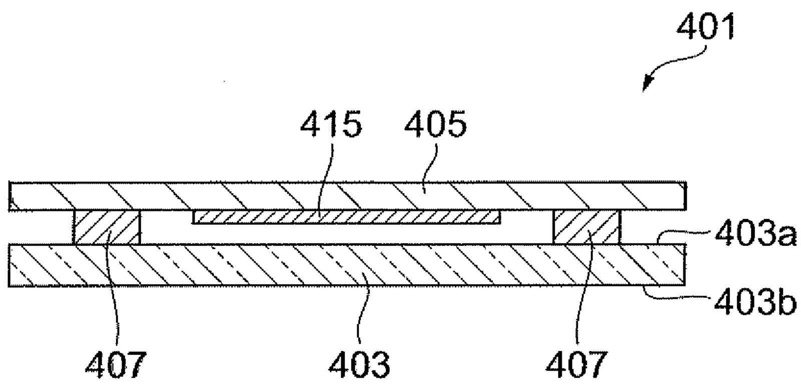

Fig.26

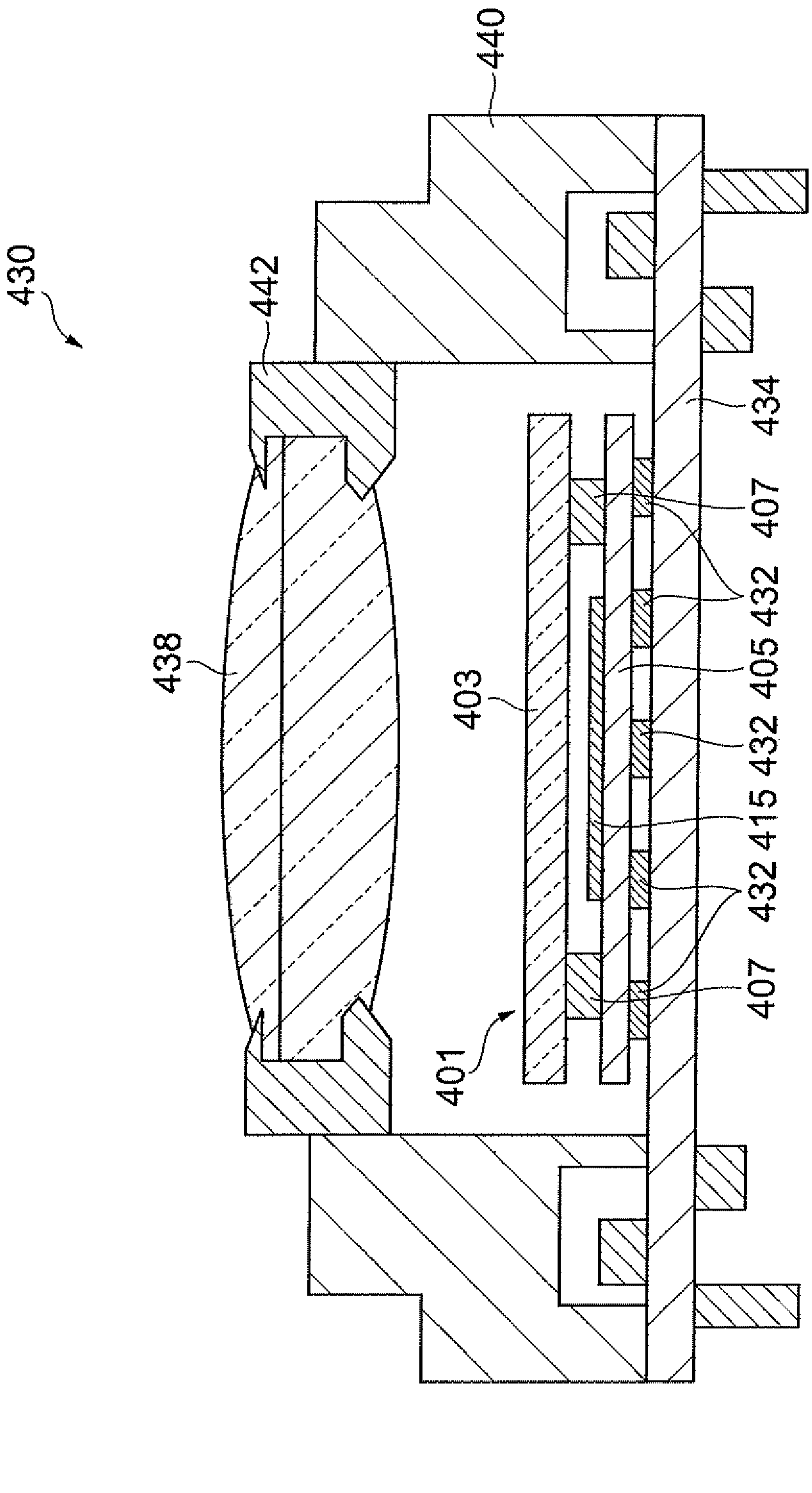

Fig.27

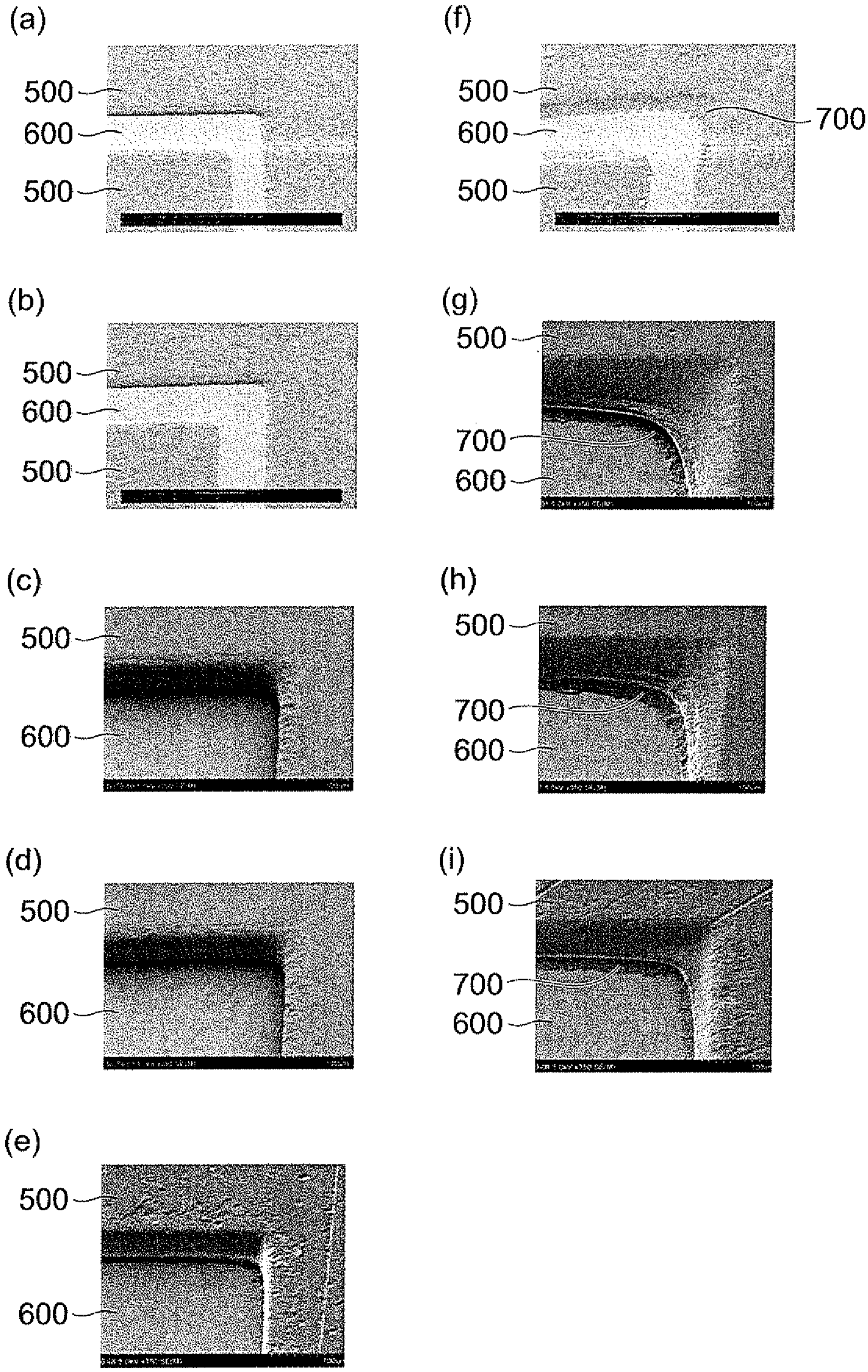
(a)
500
600
500
(f)
500
600
500
700
(b)
500
600
500
(g)
500
700
600
(c)
500
600
(h)
500
700
600
(d)
500
600
(i)
500
700
600
(e)
500
600

Fig.28

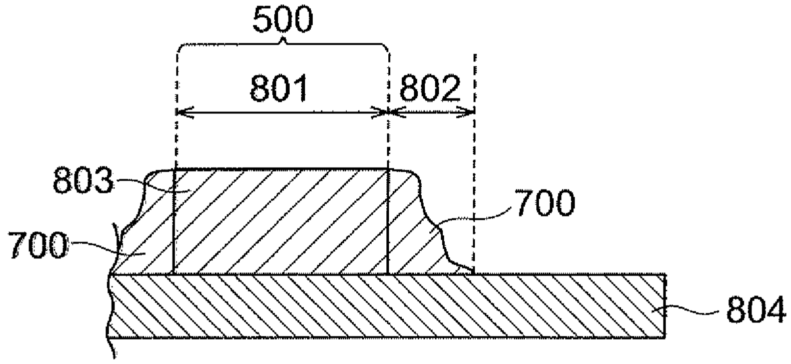

*Fig.29*

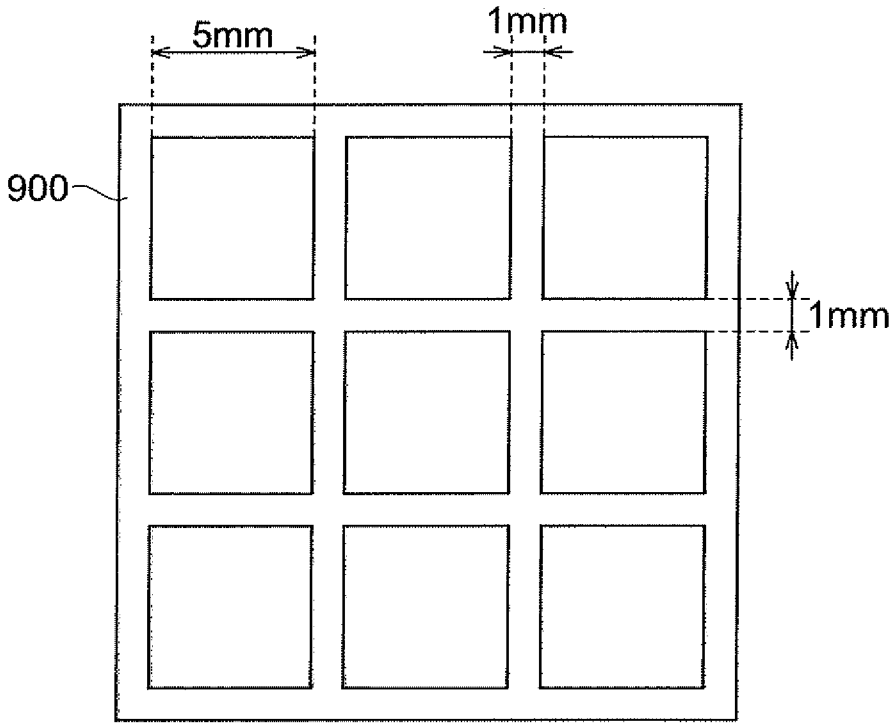

**INTERNATIONAL SEARCH REPORT**

International application No.
PCT/JP2009/064871

A. CLASSIFICATION OF SUBJECT MATTER
C09J201/00(2006.01)i, C09J4/02(2006.01)i, C09J7/00(2006.01)i, C09J7/02 (2006.01)i, C09J163/00(2006.01)i, C09J179/08(2006.01)i, C09J201/06 (2006.01)i, H01L21/52(2006.01)i

According to International Patent Classification (IPC) or to both national classification and IPC

B. FIELDS SEARCHED

Minimum documentation searched (classification system followed by classification symbols)
C09J1/00-C09J201/10, H01L21/00-H01L21/98

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2007/004569 A1 (Hitachi Chemical Co., Ltd.), 11 January 2007 (11.01.2007), claims<br>& EP 1901123 A1 & US 2008/0176167 A1<br>& CN 101218539 A & KR 2008016927 A | 1-3,6-12<br>1-12 |
| X<br>Y | JP 2008-88403 A (Hitachi Chemical Co., Ltd.), 17 April 2008 (17.04.2008), claims; examples<br>(Family: none) | 1-3,6-12<br>1-12 |
| X<br>Y | JP 2003-113205 A (Nippon Steel Chemical Co., Ltd.), 18 April 2003 (18.04.2003), claims; paragraph [0034]<br>& US 2003/0091844 A1 & CN 1408765 A<br>& KR 2003028707 A | 1-3,6-12<br>1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>22 October, 2009 (22.10.09) | Date of mailing of the international search report<br>02 November, 2009 (02.11.09) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2009/064871

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 1-179935 A (Hitachi Chemical Co., Ltd.), 18 July 1989 (18.07.1989), claims (Family: none) | 1-3,6-12<br>1-12 |
| Y | JP 38-5997 B1 (E.I. Du Pont De Nemours & Co.), 14 May 1963 (14.05.1963), claims (Family: none) | 1-12 |
| Y | JP 2001-270943 A (Mitsui Chemicals, Inc.), 02 October 2001 (02.10.2001), claims; paragraph [0044] (Family: none) | 1-12 |
| Y | JP 2008-7744 A (Toray Industries, Inc.), 17 January 2008 (17.01.2008), claims; paragraph [0045] (Family: none) | 1-12 |
| Y | JP 2008-3582 A (Osaka Prefecture University), 10 January 2008 (10.01.2008), claims; paragraph [0070] (Family: none) | 1-12 |
| P,X | WO 2008/123110 A1 (Hitachi Chemical Co., Ltd.), 16 October 2008 (16.10.2008), claims (Family: none) | 1-3,6-12 |
| P,X | JP 2008-260907 A (Hitachi Chemical Co., Ltd.), 30 October 2008 (30.10.2008), claims (Family: none) | 1-3,6-12 |
| P,X | WO 2008/149625 A1 (Hitachi Chemical Co., Ltd.), 11 December 2008 (11.12.2008), claims (Family: none) | 1-3,6-12 |
| P,X | JP 2009-164574 A (Hitachi Chemical Co., Ltd.), 23 July 2009 (23.07.2009), claims (Family: none) | 1-3,6-12 |
| P,X | WO 2009/090922 A1 (Hitachi Chemical Co., Ltd.), 23 July 2009 (23.07.2009), claims (Family: none) | 1-3,6-12 |
| E,X | JP 2009-227959 A (Hitachi Chemical Co., Ltd.), 08 October 2009 (08.10.2009), claims (Family: none) | 1-3,6-12 |

Form PCT/ISA/210 (continuation of second sheet) (April 2007)

INTERNATIONAL SEARCH REPORT

International application No.
PCT/JP2009/064871

(1)

Regarding the photosensitive adhesive composition defined in claim 1, the constituents thereof are not concretely specified. Consequently, the invention of claim 1 includes photosensitive adhesive compositions according to a very wide variety of formulations. However, the photosensitive adhesive compositions supported by the description within the meaning of PCT Article 6 and disclosed within the meaning of PCT Article 5 are only compositions according to very limited formulations.

Further, the constitution of the photosensitive adhesive composition per se is not clear, and, thus, the invention of claim 1 does not satisfy the requirement of clearness as provided for in PCT Article 6.

This is true in other claims referring to claim 1.

(2)

Specifying of the “alkali soluble resin”, the “radiation polymerizable compound”, and the “photoinitiator” defined in claim 2 do not concretely specify respective components thereof. Consequently, the invention of claim 2 includes photosensitive adhesive compositions according to a very wide variety of formulations. However, the photosensitive adhesive compositions supported by the description within the meaning of PCT Article 6 and disclosed within the meaning of PCT Article 5 are only compositions according to very limited formulations.

Further, concrete components referred to by the specified matter are not clear, and a difference in components between the compositions is not also clear. Thus, the invention of claim 2 does not satisfy the requirement of clearness as provided for in PCT Article 6.

This is true in other claims referring to claim 2.

(3)

The photosensitive adhesive compositions in claims 1 to 6 are defined by such properties that

“the photosensitive adhesive compositions are dissolvable and developable and satisfy a requirement represented by formula (1):

$(T_1/T_0) \times 100 \geq 90$ ··· (1)

wherein $T_0$ represents the thickness (μm) of the adhesive layer before development treatment; and $T_1$ represents the thickness (μm) of the adhesive pattern formed after the development. The photosensitive adhesive compositions defined in claims 1 to 6 include a very wide variety of photosensitive adhesive compositions. However, the photosensitive adhesive compositions supported by the description within the meaning of PCT Article 6 and disclosed within the meaning of PCT Article 5 are only compositions according to very limited formulations among the claimed photosensitive adhesive compositions.

Further, specifying photosensitive adhesive compositions by the above definition is not common in the art, and it is impossible even in view of the common general technical knowledge at the time of filing to concretely specify photosensitive adhesive compositions having such properties. Thus, claims 1 to 6 do not satisfy the requirement of clearness as provided for in PCT Article 6.

This is true in other claims referring to claims 1 to 6.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000290501 A
- JP 2001329233 A
- JP 11024257 A
- WO 2007004569 A


### Non-patent literature cited in the description


- *Journal of Photopolymer Science and Technology,* 1999, vol. 12, 313-314
- *Chemistry of Materials,* 1999, vol. 11, 170-176
- *Journal of American Chemical Society,* 1996, vol. 118, 12925
- *Polymer Journal,* 1996, vol. 28, 795